# EUROPÄISCHE PATENTSCHRIFT

(11) **EP 3 859 766 B1**
(45) Veröffentlichungstag und Bekanntmachung des Hinweises auf die Patenterteilung: **29.07.2026**
(21) Anmeldenummer: 21157175.7
(22) Anmeldetag: 01.04.2014
(51) Int. Cl.: H10P 70/00, H10P 72/00, H01J 37/32, C23C 14/02

(54) **VERFAHREN ZUR OBERFLÄCHENREINIGUNG VON SUBSTRATEN**
METHOD FOR SURFACE CLEANING OF SUBSTRATES
PROCÉDÉ DE NETTOYAGE DE SURFACE DE SUBSTRATS

(43) Veröffentlichungstag der Anmeldung: 04.08.2021
(62) Teilanmeldung aus: 14715265.6
(73) Patentinhaber: EV Group E. Thallner GmbH, 4782 St. Florian am Inn (AT)
(72) Erfinder: Nasser, Razek, 4782 St. Florian am Inn (AT)
(74) Vertreter: Schneider, Sascha

(56) Entgegenhaltungen:
- DE-A1- 10 210 253
- JP-A- S6 187 338
- JP-A- S61 160 938
- US-A- 5 616 179
- US-A1- 2005 230 697
- NAHOMI AOTO TAKASAKI: "Si surface study after Ar ion-assisted Cl2 etching", JOURNAL OF VACUUM SCIENCE AND TECHNOLOGY B, vol. 4, no. 4, 1 July 1986 (1986-07-01), pages 806, XP055134667, ISSN: 0734-211X, DOI: 10.1116/1.583516
- RAZEK ET AL: "Ultra-high vacuum direct bonding of a p-n junction GaAs wafer using low-energy hydrogen ion beam surface cleaning", VACUUM, PERGAMON PRESS, GB, vol. 81, no. 8, 23 March 2007 (2007-03-23), pages 974 - 978, XP022099178, ISSN: 0042-207X, DOI: 10.1016/J.VACUUM.2006.12.003
- RAZEK N ET AL: "Room-temperature ultrahigh vacuum bonding of Geâ GaAs p-n heterojunction wafer using 300eV hydrogen ion beam surface cleaning", JOURNAL OF VACUUM SCIENCE AND TECHNOLOGY: PART A, AVS /AIP, MELVILLE, NY., US, vol. 25, no. 5, 27 August 2007 (2007-08-27), pages 1480 - 1483, XP012102768, ISSN: 0734-2101, DOI: 10.1116/1.2771557

## Beschreibung

Die vorliegende Erfindung betrifft ein Verfahren zur Oberflächenreinigung von Substraten.

In der Halbleiterindustrie werden unterschiedliche nasschemische Ätzverfahren und/oder Trockenätzverfahren zur Oberflächenbehandlung, insbesondere Oberflächenreinigung und Oberflächenaktivierung verwendet. Diese dienen vor allem der Entfernung nativer Oberflächenoxide und/oder Kohlenstoffverbindungen. Der gravierende Unterschied zwischen den nasschemischen Ätzverfahren und den Trockenätzverfahren ist der Aggregatzustand der verwendeten Reinigungsspezies. Bei einem nasschemischen Ätzverfahren werden Flüssigkeiten, bei einem Trockenätzverfahren Gase bzw. Plasmen zur Reinigung der Substratoberfläche verwendet. Nasschemische Ätzverfahren besitzen in einigen Anwendungsfällen immer noch ihre Berechtigung, wurden allerdings in den letzten Jahren in vielen anderen Anwendungsgebieten durch Trockenätzanlagen ersetzt.

JPS61160938 offenbart ein Verfahren zur Beseitigung von Schäden durch einen Niedrigtemperaturprozess. JPS6187338 offenbart ein Verfahren zur Trockenreinigung. Nahomi Aoto Takasaki:"Si surface study after Ar ionassisted Cl2 etching",XP055134667 untersucht die Auswirkungen von Argonionen-unterstütztem Chlor-Etching. DE10210253 offenbart ein Verfahren zur Reinigung von Halbleiteroberflächen. Razek et al. "Ultra-high vacuum direct bonding of a p-n junction GaAs wafer using low-energy hydrogen ion beam surface cleaning", XP022099178 zeigt, dass sich Wafer nach einer Reinigung direkt verbinden lassen. Razek N et al:"Room-temperature ultrahigh vacuum bonding of Ge/GaAs heterojunction wafer using 300eV hydrogen ion beam surface cleaning", XP012102768 zeigen, dass sich Wafer nach einer Oberflächenreinigung vollständig verbinden lassen. US5616179 offenbart ein Verfahren zum Aufbringen von amorphen Filmen auf ein Substrat. EP0737258 offenbart ein Verfahren zur Abscheidung kohlenstoffbasierter Filme. US2005230697A1 offenbart eine Vorrichtung.

Zum Trockenätzen verwendet man hauptsächlich Plasmaanlagen oder Ionensputteranlagen.

Unter einer Plasmaanlage versteht man eine Anlage, die ein quasineutrales Gas, ein sogenanntes Plasma, erzeugen kann. Durch das Anlegen einer Spannung zwischen den beiden Elektroden wird das Prozessgas ionisiert und bildet ein ionisiertes, quasineutrales Gas, das sogenannte Plasma. Diese Anlagen werden als "capacitively coupled plasma"(CCP)-Plasmaanlagen bezeichnet. Denkbar ist auch die Erzeugung von Plasma durch magnetische Vorrichtungen in sogenannten "inductively coupled plasma"(ICP)-Plasmaanlagen. Dabei verwendet man die elektromagnetische Induktion zu Herstellung eines Plasmas. Des Weiteren existieren noch andere Methoden um Plasmen zu erzeugen, auf die hier nicht näher eingegangen werden soll. Die weiteren Ausführungen gelten im Allgemeinen für alle Plasmaanlagen, werden aber mit Hilfe von CCP-Plasmaanlagen beschrieben, da deren Aufbau relativ simpel ist.

Dieses Plasma wirkt dann durch seine ihm charakteristischen Eigenschaften auf die Oberfläche eines Substrats, die sich vorzugsweise auf oder in der Nähe einer der beiden Elektroden befindet, ein. Im Allgemeinen können entweder inerte oder reaktive Prozessgase verwendet werden. Bei einer Plasmaanlage gibt man die Spannung zwischen zwei Elektroden, die Gaszusammensetzung und den Gasdruck vor. Niedertemperaturplasmen entzünden sich dabei oberhalb eines kritischen Drucks. Dieser kritische Druck ist groß im Vergleich zu den Drücken in einer Hochvakuumkammer, allerdings kleiner als 1bar. Niedertemperaturplasmen bestehen meistens aus Sauerstoff, Stickstoff, Edelgasen oder komplexeren organischen gasförmigen Verbindungen. Diese modifizieren die Substratoberfläche sowohl physikalisch durch Ionenbeschuss, als auch chemisch durch im Plasma erzeugte Radikale (Quelle: S. Vallon, A. Hofrichter et. Al, Journal of Adhesion Science and Technology, (1996) vol. 10, no. 12, 1287). Die physikalische Modifikation ist vor allem auf die hohe Geschwindigkeit und die damit einhergehenden Stoßenergien zwischen Gas- und Plasmaatomen mit den Atomen der Substratoberfläche zurückzuführen.

Ionensputteranlagen hingegen besitzen eine Ionenquelle, und eine Beschleunigungseinheit. In der Ionenquelle wird ein Prozessgas ionisiert und über die Beschleunigungseinheit in Richtung Substratoberfläche beschleunigt. Die beschleunigten Ionen bilden den sogenannten Ionenstrahl, der einen mittleren Durchmesser, eine entsprechende Divergenz oder Konvergenz und eine Energiedichte besitzt. Die beschleunigten Ionen können Verunreinigungen von der Substratoberfläche lösen, wenn ihre kinetische Energie größer oder zumindest gleich groß ist wie die Bindungsenergie zwischen der Verunreinigung und der Substratoberfläche. Bei diesem Prozess kann die kinetische Energie der Ionen allerdings auch die Substratoberfläche selbst beeinflussen. Diese Beeinflussung zeigt sich in der Veränderung der Mikrostruktur der Substratoberfläche, in der Erzeugung von Punktdefekten, eingebauten Ionen im Kristallgitter, plastischer Verformung etc.

Die Entfernung von Verunreinigungen nennt man Sputtern. Der Vollständigkeit halber sei darauf hingewiesen, dass der Abscheidevorgang von Atomen an Oberflächen auch als Sputtern bezeichnet werden kann. Im weiteren Verlauf wird unter Sputtern allerdings immer nur der Atomabtrag verstanden.

Ein technisches Problem besteht darin, dass es unter den gegebenen Umgebungsbedingungen zu einer Reaktion zwischen den zu entfernenden Verunreinigungen am Substrat und den Ionen kommen kann, ohne dass die Verunreinigungen dabei von der Substratoberfläche entfernt werden. Des Weiteren reagieren die Ionen meist auch mit dem zu reinigenden Grundmaterial, das sich unterhalb der zu entfernenden Verunreinigungen befindet. Das hat eine inhomogene Abtragung und damit eine Erhöhung der Oberflächenrauigkeit zur Folge.

Des Weiteren kommt es häufig zu einer Adsorption der Gas- und Plasmaatome an der Oberfläche des Substrats.

Die Entfernung von Verunreinigungen, insbesondere mittels Wasserstoff, erfolgt nach dem Stand der Technik im Wesentlichen unter Verwendung folgender Verfahren:

### Plasmaverfahren

1. Die Substratoberfläche wird mittels eines Wasserstoffplasmas bestrahlt. Dabei wird die Temperatur der Oberfläche meistens sehr stark durch das Plasma erhöht. Im Allgemeinen werden für unterschiedliche Materialien auch unterschiedliche Plasmaprozesse verwendet. Für InP verwendet man beispielsweise eine sogenanntes ECR (engl.: electron cyclotron resonance) Plasma (Quelle: A. J. Nelson, S. Frigo, D. Mancini, und R. Rosenberg, J. Appl. Phys. 70, 5619 (1991)). Die Entfernung aller Oberflächenverunreinigungen von GaAs wurde nach Wasserstoffbestrahlung mittels eines RF (engl.: radio-frequency) Plasmas bei einer Temperatur von 380 °C nach etwa 30 Minuten beobachtet (Quelle: S. W. Robey und K. Sinniah, J. Appl. Phys. 88, 2994 (2000)). Für CuInSe₂ wird die Entfernung von Oberflächenoxiden beispielsweise durch Verwendung eines Wasserstoff-ECR-Plasmas bei 200°C Probentemperatur beschrieben (Quelle: A. J. Nelson, S. P. Frigo, und R. Rosenberg, J. Appl. Phys. 73, 8561 (1993)).
2. Die Substratoberfläche wird unter Einwirkung von molekularem Wasserstoff im Vakuum auf mehr als 500 °C aufgeheizt. Beim GaAs wird dafür beispielsweise eine Reinigungszeit von bis zu 2 Stunden benötigt (Quelle: DE 100 48 374 A1).
3. Die Substratoberfläche wird unter Anwendung von atomarem Wasserstoff im Vakuum aufgeheizt. Beim GaAs erfolgt dies z.B. vorzugsweise in einem Temperaturbereich zwischen 350 °C bis 400 °C. Dieses Verfahren ist ausführlich in der Literaturstelle (Quellen: Y. Ide und M. Yamada, J. Vac. Sci. Technol. A 12, 1858 (1994) oder T. Akatsu, A. Plößl, H. Stenzel, und U. Gösele, J. Appl. Phys. 86, 7146 (1999) und DE 100 48 374 A1) beschrieben.

### Ionenstrahlverfahren

Die Entfernung von Oberflächenverunreinigungen mittels inerter Gase (Ar, N₂. Xenon, ...) eines Ionenstrahlverfahrens basiert vorwiegend auf der Basis eines reinen Sputterabtrages (Quelle: J. G. C. Labanda, S. A. Barnett and L. Hultman "Sputter cleaning and smoothening of GaAs(001) using glancingangle ion bombardment", Appl. Phys. Lett. 66, 3114 (1995)). Die Verwendung reaktiver Gase (H₂, O₂, N₂, CF₅) beruht hingegen überwiegend auf einer chemischen Reaktion des Prozessgases mit den Oberflächenverunreinigungen und der nachfolgenden Entfernung der Reaktionsprodukte (Desorption, z.T. thermisch oder durch Ionenbeschuss stimuliert). Wasserstoff hat sich dabei als ein bevorzugtes Prozessgas für die Entfernung von verschiedensten Oberflächenoxiden und Kohlenstoffverunreinigungen auf der Oberfläche von Halbleitern herausgestellt (Quelle: DE 10 210 253 A1).

Die im Stand der Technik genannten Methoden der Oberflächenreinigung dienen im Allgemeinen zur Vorbehandlung der Substratoberfläche für einen folgenden Prozess. Folgende Prozesse sind beispielsweise eine Beschichtung mit einem Photolack, eine Abscheidung von einer oder mehreren Atomen bzw. Molekülen durch einen Gasphasenabscheideprozess wie beispielswese PVD (engl.: physical vapor deposition) oder CVD (engl.: chemical vapor deposition).

Durch die Ionen werden vor allem in Halbleitermaterialien Oberflächendefekte generiert, welche die elektrische Funktion von Bauelementen entscheidend beeinträchtigen können. Des Weiteren tritt im Stand der Technik das grundsätzliche Problem auf, dass Plasmaanlagen und Sputteranlagen die Substratoberfläche grundsätzlich immer modifizieren, und daher meist schädigen.

Bei Verwendung von Plasmaprozessen oder Ionensputterprozessen zur Reinigung oder Aktivierung von beispielsweise Si-, SiC-, Quarz- oder 3A-5B-Halbleiteroberflächen treten als wesentlicher Nachteil zusätzliche Schäden an der Oberfläche des Halbleiters auf (z.B. Rauheit, Ausbildung metallischer Phasen, Aufwachsen von Oxidschicht, Ausbildung einer dünnen Wasserhaut). Durch die Plasmaanlagen erfolgt zwar bei den meisten Verunreinigungen eine nachweisbare, effiziente Oberflächenreinigung, dennoch zeigt sich vor allem bei organischen Komponenten, dass diese Reinigungsmethode nicht ausreicht, um die organischen Verbindungen vollständig zu entfernen.

Der Hauptgrund für die Schadenserzeugung durch Plasmaanlagen ist im Wesentlichen der direkte Kontakt des Plasmas mit der Halbleiteroberfläche und die daraus resultierende Wechselwirkung zwischen Plasmabestandteilen (z.B. Ionen, radikale und hochangeregte Moleküle/Atome, Elektronen und UV-Photonen) und den Atomen an der Substratoberfläche. Insbesondere die hochangeregten, und damit hochenergetischen, Teilchen bzw. die Ionen eines Plasmas bzw. die Teilchen bzw. Ionen einer Ionensputteranlage erzeugen mit großer Wahrscheinlichkeit nachteilige Schädigungsprozesse der Substratoberfläche, insbesondere einer hochsensiblen Halbleiteroberfläche.

Die mittels Sauerstoff, Stickstoff, Edelgasen oder komplexeren organischen gasförmigen Verbindungen erzeugten Niedertemperaturplasmen modifizieren die Substratoberfläche sowohl durch Ionenbeschuss als auch durch Oberflächenreaktionen mittels im Plasma vorhandener Radikale (Quelle: K. Harth, Hibst,H., Surface and Coatings technology (1993) vol. 59, no. 1-3, 350). Zusätzlich werden Gasatome an der Oberfläche absorbiert (Quelle: K. Scheerschmidt, D. Conrad, A. Belov, H. Stenzel, "UHV-Silicon Wafer Bonding at Room temperature: Molecular Dynamics and Experiment", in Proc. 4. Int. Symp. on Semiconductor Wafer Bonding, September 1997, Paris, France, p. 381).

Der entscheidende Nachteil bei den Verfahren zur Reinigung von Halbleiteroberflächen unter Einwirkung von atomarem oder molekularem Wasserstoff in Vakuumumgebung sind die erforderlichen hohen Temperaturen, die gewöhnlich mindestens zwischen 400°C und 500°C liegen (siehe: DE 100 48 374 A1). Die hohen Prozesstemperaturen sind erforderlich, um sowohl eine effektive Reaktion des Wasserstoffs mit den Verunreinigungen als auch die Desorption von Teilen der entstandenen Reaktionsprodukte zu ermöglichen.

Ein weiterer Nachteil der im Stand der Technik beschriebenen Methoden zur Reinigung von Halbleiteroberflächen mittels molekularen und/oder atomaren Wasserstoff sind die langen Prozesszeiten, die im Fall von molekularem Wasserstoff mindestens zwei Stunden betragen (siehe: DE 100 48 374 A1).

Die Verwendung der erfindungsgemäßen Ausführungsform aus der Patentschrift DE 102 10 253 A1 ist nicht effizient genug, da die Entfernung der Verunreinigungen durch einen rein chemischen Prozess mittels Wasserstoff-Ionen von Si, SiO₂, SiC Quarz und Zerodur nicht zu einer vollständigen Entfernung führt.

Aufgabe der vorliegenden Erfindung ist es daher, ein neues Verfahren zu schaffen, das die Entfernung von chemischen Verunreinigungen oder störenden Substratoberflächenschichten (z.B. Oxide, einschließlich natürliche Oxide, Kohlenstoff und Kohlenstoffverbindungen) auf der Oberfläche von Substraten, insbesondere Halbleitern, ohne die Erzeugung zusätzlicher Schäden (z. B. Erhöhung der Oberflächenrauheit, Stöchiometrieänderung und Kristallgitterschäden) an der Substratoberfläche oder im Volumen bei geringstmöglicher Schädigung der Substratoberfläche erlaubt.

Diese Aufgabe wird mit den Merkmalen des Anspruchs 1 gelöst. Vorteilhafte Weiterbildungen der Erfindung sind in den Unteransprüchen angegeben.

Die Erfindung betrifft ein Verfahren zur Oberflächenreinigung einer Substratoberfläche eines Substrats bei Raumtemperatur mit folgenden Schritten:
- Anordnung der Substratoberfläche in einer Prozesskammer,
- Beaufschlagung der Substratoberfläche mit einem von einer Ionenstrahlquelle erzeugten, auf die Substratoberfläche (7o) gerichteten Ionenstrahl zur Ablösung von Verunreinigungen von der Substratoberfläche, wobei der Ionenstrahl eine erste Komponente aufweist,
- Einleitung einer zweiten Komponente in die Prozesskammer (8) zur Bindung der abgelösten Verunreinigungen,
wobei ein Abstand zwischen einem Substratprobenhalter (5) und einer Austrittsöffnung der Ionenstrahlquelle (2, 2', 2") kleiner ist als 100 cm, wobei die zweite Komponente gasförmig in die Prozesskammer (8) geleitet wird.

Offenbart wird weiterhin eine Vorrichtung zur Oberflächenbehandlung einer Substratoberfläche eines Substrats mit:
- einer Prozesskammer zur Aufnahme des Substrats,
- einer Ionenstrahlquelle zur Erzeugung eines eine erste Komponente aufweisenden, auf die Substratoberfläche gerichteten Ionenstrahls zur Ablösung von Verunreinigungen von der Substratoberfläche,
- Mittel zur Einleitung einer zweiten Komponente in die Prozesskammer zur Bindung der abgelösten Verunreinigungen.

Die Grundidee der vorliegenden Erfindung ist es, die Substratoberfläche eines Substrats vor einer weiteren Bearbeitung in einer Prozesskammer mit einem gerichteten Ionenstrahl von Verunreinigungen zu befreien, wobei der Ionenstrahl eine erste, insbesondere gasförmige, Komponente aufweist und eine zweite gasförmige Komponente beziehungsweise ein Arbeitsgas in die Prozesskammer eingeleitet wird. Die zweite Komponente dient zur Bindung der abgelösten Verunreinigungen. Bevorzugt wird die zweite Komponente durch die Prozesskammer mit einer Strömungsgeschwindigkeit durchgeleitet, um die Verunreinigungen aus der Prozesskammer auszutragen.

Unter erste Komponente oder zweite Komponente sind erfindungsgemäß insbesondere Gasgemische oder reine Gase, insbesondere reine Edelgase, subsumiert.

Die Erfindung betrifft mit anderen Worten eine Methode zur Oberflächenreinigung von verschieden Materialien, insbesondere Halbleitermaterialien, bei Raumtemperatur (R_{T}) mittels, insbesondere niederenergetischem, Ionensputtern und/oder Formiergas.

Das Formiergas hat vorzugsweise einen Wasserstoffanteil größer als 20 Prozent. Unter einem Formiergas versteht man dabei vorzugsweise Gasgemische aus Argon (Ar) und Wasserstoff (H₂), oder Gasionengemische aus Stickstoff (N₂) und Wasserstoff (H₂). Denkbar ist allerdings auch, dass das Formiergas nur aus einer einzelnen Gaskomponente, insbesondere nur aus Argon oder nur aus Wasserstoff besteht.

Die Erfindung handelt daher insbesondere von einem Verfahren, welche eine Substratoberfläche bei Raumtemperatur, von Kontaminationen befreit, ohne die Substratoberfläche zu beschädigen. Das Verfahren ist bevorzugt für die kostengünstige Reinigung von Halbleitern und Halbleiterstrukturen einsetzbar. Bevorzugt wird die erfindungsgemäße Methode verwendet, um Substratoberflächen für einen anschließenden Bond, insbesondere einen Permanentbond, vorzubereiten.

Die bevorzugteste Ausführungsform verwendet Breitbandionenstrahlen zur Oberflächenreinigung der Substratoberfläche.

In einer vorteilhaften Ausführungsform wird die Oberflächenreinigung nicht vollflächig, sondern positionsselektiv durchgeführt. Diese Ausführungsform wird insbesondere in den Bereichen Optik, Optoelektronik und Sensorik verwendet, um ausschließlich definierte/vorgegebene Bereiche der Substratoberfläche zu reinigen. Die positionsselektive Oberflächenreinigung erfolgt dabei entweder durch einen direkt durch Fokussierung erzeugten Schmalbandionenstrahl oder durch einen, mittels einer Blende aus einem Breitbandionenstrahl erzeugten Schmalbandionenstrahl. Eine weitere erfindungsgemäße Möglichkeit wäre die Maskierung des Substrates mit einem entsprechend belichteten und chemisch behandelten Photoresist. Der Photoresist dient dann als Positiv- oder Negativmaske. Eine weitere, erfindungsgemäße Möglichkeit wäre die Verwendung einer mechanischen Schattenmaske.

Ein erfindungsgemäßer Gedanke besteht insbesondere darin, die Ionen der ersten Komponente durch eine Ionenquelle, insbesondere durch eine Breitstrahlionenquelle, auf die Substratoberfläche zu beschleunigen. Die Prozesskammer wird zusätzlich mit einem Formiergas, oder bevorzugter mit reinem Wasserstoff, als zweite Komponente gespült. Bei Verwendung von Breitstrahlionenquellen können die chemischen Kontaminationen (native Oxide, Kohlenstoff, Verunreinigungen) auf dem Substrat durch Niederenergieionen (<1000eV) ohne schädliche Auswirkungen auf die Oberflächen von Substraten entfernt werden. Ein weiterer Vorteil der Verwendung einer Breitstrahlionenquelle besteht ihn der Reinigung eines sehr großen, im Extremfall die gesamte Substratoberfläche umfassenden, Flächenabschnittes der Substratoberfläche.

Der Erfindung liegt dabei insbesondere die Verwendung einer Niederenergie Ionensputteranlage zugrunde, welche Ionen auf eine Substratoberfläche schießt. Die Ionen werden vorzugsweise in einem Breitbandionenstrahl auf die Substratoberfläche geschossen. Unter einem Breitbandionenstrahl versteht man einen Ionenstrahl, dessen mittlerer Durchmesser im Größenordnungsbereich des Durchmessers des Substrats liegt. Das Verhältnis zwischen dem Ionenstrahldurchmesser und dem Durchmesser des Substrats ist dabei insbesondere größer als 1/100, mit Vorzug größer als 1/10, mit größerem Vorzug größer als 1/2, mit größtem Vorzug größer gleich 1. Der Breitbandionenstrahl deckt vorzugsweise die gesamte Substratoberfläche ab.

Soweit der Durchmesser des Ionenstrahls an der Substratoberfläche kleiner als der Durchmesser der Substratoberfläche ist, wird erfindungsgemäß insbesondere eine Relativbewegung zwischen dem Ionenstrahl und der Substratoberfläche erfolgen, um alle zu reinigenden Positionen an der Substratoberfläche zu erreichen. Vorzugsweise erfolgt die Relativbewegung durch eine Bewegung des Substratprobenhalters relativ zur Ionenquelle. Bei dieser Ausführungsform wird eine positionsspezifische, daher ortsaufgelöste, Reinigung von Substratoberflächen ermöglicht. Insbesondere ist hierbei die Verwendung eines Schmalbandionenstrahls denkbar, wobei das Verhältnis zwischen dem Durchmesser des Ionenstrahls und dem Durchmesser der Substratoberfläche kleiner als 1, mit Vorzug kleiner als 1/10, mit größerem Vorzug kleiner als 1/100, mit größtem Vorzug kleiner als 1/1000 eingestellt wird. Je kleiner das Verhältnis, desto größer ist die Auflösung eines Reinigungsvorganges, aber desto länger benötigt man um ein entsprechendes Gebiet auf dem zu reinigenden Substrat durch eine Relativbewegung zu reinigen. Der Schmalbandionenstrahl kann entweder durch optische Elemente direkt fokussiert oder durch Masken und Blendentechnik aus einem Breitbandionenstrahl erzeugt werden. Die optischen Elemente bestehen insbesondere aus elektrischen und/oder magnetischen Linsen und werden unter dem Begriff Optik zusammengefasst. Bei der Verwendung von Masken und Blendentechnik kann vorzugsweise ein automatisierte Einheit, insbesondere ein Roboter, verwendet werden um Masken bzw. Blenden mit unterschiedlichen Aperturen schnell zu wechseln. Denkbar ist auch die Erzeugung eines Schmalbandionenstrahl durch eine Quelle, die einen entsprechend geringen Querschnitt aufweist.

Ein erfindungsgemäßer Aspekt besteht, unabhängig vom verwendeten Ionenstrahldurchmesser, insbesondere in der Verwendung einer niederenergetischen Ionensputteranlage in Verbindung mit einem entsprechenden Formiergas, insbesondere einem reinen Argon oder reinem Wasserstoffgas (zweite Komponente). Das Formiergas wird dabei als Prozessgas für die Ionenerzeugung in der Ionenquelle der Ionensputteranlage und/oder als Spülgas in der Prozesskammer verwendet. Durch die erfindungsgemäße Kombination einer niederenergetischen Ionensputteranlage mit einem entsprechenden Formiergas wird sichergestellt, dass die Substratoberfläche zwar von Verunreinigungen gesäubert, nicht jedoch modifiziert oder gar geschädigt wird. Ein erfindungsgemäßer Aspekt besteht daher darin, dass zwar niederenergetische Ionen durch die Ionensputteranlage auf die Substratoberfläche beschleunigt werden, deren Energie allerdings nicht ausreicht, um eine nennenswerte Modifikation oder Schädigung des Substrats hervorzurufen. Die Schädigung ist allenfalls sehr gering und wird durch einen Tiefenbereich angegeben, innerhalb dessen noch eine Änderung der Mikrostruktur des Substrats nachweisbar ist.. Dieser Tiefenbereich ist durch die Anwendung der erfindungsgemäßen Methode insbesondere kleiner als 10µm, mit Vorzug kleiner als 1µm, mit größerem Vorzug kleiner als 100nm, mit größtem Vorzug kleiner als 15nm, mit noch größerem Vorzug kleiner als 7nm, noch bevorzugter kleiner als 3nm, noch bevorzugter kleiner als 1.5nm, am bevorzugtesten gleich null. Im Idealfall findet also überhaupt keine Schädigung durch den Ionenbeschuss statt.

Die spezifisch auf die Verunreinigung und/oder die Substratoberfläche abgestimmte erste Komponente (insbesondere Formiergas) reagiert mit den abgesputterten Atomen/Molekühlen der Verunreinigungen und verhindert damit erfindungsgemäß deren erneute Ablagerung an der Substratoberfläche. Die so gebildeten, durch die erste Komponente gebundenen Verbindungen werden vorzugsweise durch ein Vakuumsystem abgesaugt oder durch Fallen in der Prozesskammer gebunden, sodass deren erneute Abscheidung auf der Substratoberfläche unterbunden wird. Durch ein zusätzliches Spülen der Prozesskammer mit der zweiten Komponente (insbesondere einem Formiergas, vorzugsweise demselben Formiergas welches in der Ionenquelle ionisiert wird) kann der erfindungsgemäße Prozess optimiert und beschleunigt werden. Mit besonderem Vorzug kann ein Breitbandionenstrahl verwendet werden um eine vollflächige Säuberung durchzuführen.

Die erfindungsgemäße Ausführungsform stellt eine effiziente, kostengünstige Möglichkeit dar, Oberflächenverunreinigungen, insbesondere kohlenstoffhaltige Verunreinigungen, zu entfernen. Die erfindungsgemäße Ausführungsform kann grundsätzlich auf alle Arten von Substratoberflächen angewandt werden, besitzt aber vor allem bei Substratoberflächen mit sehr geringer Rauhigkeit eine besondere Effizienz. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit ist erfindungsgemäß insbesondere kleiner als 100 µm, vorzugsweise kleiner als 10 µm, noch bevorzugter kleiner als 1 µm, am bevorzugtesten kleiner als 100nm, am allerbevorzugtesten kleiner als 10nm. Die erfindungsgemäße Ausführungsform eignet sich insbesondere auch zur Reinigung von Substraten, auf denen optische Elemente gefertigt werden. Des Weiteren ist auch eine Reinigung von Substraten mit funktionalen Elementen möglich, die eine relativ komplizierte Topographie besitzen, beispielsweise Diffraktionsgitter, Fresnellinsen, MEMs devices, Kavitäten für die Aufnahme von LEDs.

Gleichzeitig wird durch die Auswahl einer hinreichend niedrigen kinetischen Ionenenergie die Erzeugung von Schäden im Halbleitermaterial verhindert.

Eine Anlage, die zum erfindungsgemäßen Verfahren eingesetzt werden kann, besteht aus mindestens einer Hochvakuumkammer mit einer zusätzlich angeschlossenen Breitstrahlionenquelle vom Kaufmann-typ oder RF-Breiteionenquelle (Quelle: K. Otte. A. Schindler, F. Bigl, and H. Schlemm, Rev. Sci. Instrum., 69, 1499 (1998)). Der Durchmesser der Breitbandionenquelle liegt insbesondere zwischen 10 mm und 1000 mm, mit Vorzug zwischen 20 mm und 800 mm, mit größerem Vorzug zwischen 30 mm und 600 mm, mit größtem Vorzug zwischen 40 mm und 400 mm.

Die Ionenanlage kann vollständig evakuiert werden. Eine derartige Evakuierung der Prozesskammer findet insbesondere vor der Einleitung des Arbeitsgases beziehungsweise der zweiten Komponente statt. Die Ionenanlage kann auf einen Druck kleiner 1 bar, mit Vorzug kleiner als 10⁻³ mbar, mit größerem Vorzug kleiner als 10⁻⁵ mbar, mit größtem Vorzug kleiner als 10⁻⁷ mbar, mit allergrößtem Vorzug kleiner als 10⁻⁸ mbar evakuiert werden. Nach der Evakuierung findet eine Spülung der Ionenanlage mit dem Arbeitsgas statt. Die Spülung erfolgt bis zum Erreichen eines Arbeitsdrucks.

Der Arbeitsdruck in der Ionenkammer liegt dabei insbesondere zwischen 10⁻⁸ mbar und 1bar, mit Vorzug zwischen als 10⁻⁶ mbar und 1 bar, mit größerem Vorzug zwischen 10⁻⁶ mbar und 1 mbar, mit größtem Vorzug zwischen 10⁻⁵ mbar und 1 mbar.

Der Arbeitsdruck der zweiten Komponente beziehungsweise des Arbeitsgases liegt insbesondere zwischen 1x10⁻³ mbar und 8x10⁻⁴ mbar. In die für die Reinigung der Substratoberfläche verwendete Breitstrahlionenquelle wird ein kontrollierter Gasfluss von Gasgemisch (Argon mit Wasserstoff),(Stickstoff mit Wasserstoff) oder reinem Wasserstoff von 1 bis 100 sccm/min ("Standard-cm³/min." = "cm³/min. bei Standardbedingungen") eingelassen. In besonderen Ausführungsformen wird, insbesondere reiner, Wasserstoff verwendet.

Beispielsweise ist der Substratprobenhalter auf einem Tisch montiert, und fixiert, der über mindestens einen Rotationsfreiheitsgrad, mit Vorzug über mindestens zwei Rotationsfreiheitsgrade am bevorzugtesten über drei, insbesondere normal zueinander angeordnete, Rotationsfreiheitsgrade verfügt.

Beispielsweise ist der Substratprobenhalter auf einem Tisch montiert und fixiert, der über mehrere Translations- und Rotationsfreiheitsgrade verfügt. Der Tisch kann sich mindestens entlang einer X- und einer dazu senkrechten Y-Richtung bewegen. Bevorzugt besitzt der Tisch auch einen Freiheitsgrad in einer senkrecht zur X- und Y-Richtung verlaufenden Z-Richtung. In einer besonders bevorzugten Variante besitzt der Tisch noch weitere, insbesondere genau drei, Freiheitsgrade der Rotation. Damit ist es möglich, den Substratprobenhalter innerhalb der Prozesskammer in allen Richtungen zu verfahren und in alle Richtungen auszurichten. Der Ioneneinfallswinkel ist definiert als der Winkel zwischen dem Ionenstrahl (genauer der zentrischen Achse bzw. der Symmetrieachse des Ionenstrahls) und der Normalen auf die Substratoberfläche. Der Ioneneinfallswinkel ist zwischen 0° (senkrechter Einfall) und 90° (paralleler Einfall zur Substratoberfläche) frei einstellbar. Der Ioneneinfallswinkel ist insbesondere kleiner als 90°, mit Vorzug kleiner als 70°, mit größerem Vorzug kleiner als 50°, mit größtem Vorzug kleiner als 30°, mit allergrößtem Vorzug gleich 0°. Da die Ionenquelle vorzugsweise statisch in Bezug auf die Prozesskammer fixiert wird, stellt man den Ioneneinfallswinkel durch eine Rotation des Substrats, insbesondere durch Kippen des Substratprobenhalters, ein. Denkbar, wenn auch nicht bevorzugt, wäre auch eine bewegbare Ionenquelle und damit die Einstellung des entsprechenden Ioneneinfallswinkels über die Bewegung der Ionenquelle.

Durch die Verwendung besonderer Breitbandionenquellen und der Tatsache, dass man mit derartigen Ionenquellen in der Lage ist, die gesamte Fläche eines Substrats relativ gleichmäßig mit Ionen zu bestrahlen, kommt in besonderen Variationen auch ein statischer Substratprobenhalter und/oder Tisch in Frage.

Der Abstand zwischen dem Substratprobenhalter und einer Austrittsöffnung der Ionenquelle ist erfindungsgemäß kleiner als 100cm, mit Vorzug kleiner als 80cm, mit größtem Vorzug kleiner als 60cm, mit allergrößtem Vorzug kleiner als 40cm. In ganz besonderen Ausführungsformen kann die Energie der Ionen an der Substratoberfläche durch den Abstand des Substrats zur Austrittsöffnung der Ionenquelle in Verbindung mit einer korrekt eingestellten Formiergasdichte eingestellt werden. Insbesondere sind hierfür Messmittel zur Messung des Abstands vorgesehen.

Der Substratprobenhalter kann durch mindestens einen Heizer, insbesondere mehrere Heizer, auf eine Temperatur zwischen 0°C bis 500°C aufgeheizt werden. Die Substrattemperatur wird, insbesondere in Verbindung mit Temperatursensoren, zwischen 0°C und 500°C, vorzugsweise zwischen 0°C und 400°C, noch bevorzugter zwischen 0°C und 300°, am bevorzugtesten zwischen 0°C und 200°C, am allerbevorzugtesten zwischen 0°C und 250°C eingestellt.

Der Substratprobenhalter ist vorzugsweise über einen Computer und/oder einen Mikrokontroller und/oder eine Firmware und/oder eine entsprechende Software steuerbar.

Mit besonderem Vorzug können Anfahrpositionen programmiert werden, sodass der Substratprobenhalter ein vorgegebenes Gebiet der Substratoberfläche vollautomatisch abrastern kann. Damit können optimale Abrasterungstechniken gespeichert und auf Knopfdruck wieder abgerufen werden. Diese Möglichkeit ist vor allem bei der Verwendung von Schmalbandionenquellen sinnvoll, um alle zu reinigenden Positionen der Substratoberfläche erreichen zu können. Bei der Verwendung von Breitbandionenquellen kann eine, insbesondere lineare und/oder rotatorische, Verschiebung des Substratprobenhalters während der Bestrahlung mit Ionen zur Homogenisierung des erfindungsgemäßen Effektes betragen. Dabei sind vor allem hochfrequente lineare und rotatorische Bewegungen vorteilhaft. Die Frequenz des Substratprobenhalters, daher die Anzahl der Schwingungen, die der Substratprobenhalter pro Sekunde in eine beliebige Richtung durchführt, ist dabei insbesondere größer als 1/100, mit Vorzug größer als 1/10, mit größerem Vorzug größer als 1, mit größtem Vorzug größer als 10, mit allergrößtem Vorzug größer als 100. Die Anzahl der Umdrehungen pro Minute (engl.: rounds-per-minute rpm) des Substratprobenhalter ist größer als 1/10, mit größerem Vorzug größer als 1, mit größtem Vorzug größer als 10, mit allergrößtem Vorzug größer als 100.

### Die Ionenquelle

Die Ionenquelle ist nicht Teil der Erfindung.

Der innere Aufbau der Ionenquelle, die bevorzugt verwendet wird, entspricht etwa dem Kaufmann-Typ. Ein Unterschied besteht insbesondere im Extraktionsgittersystem. Die aus dem Plasmaraum extrahierten Ionen werden in dem zusätzlichen Gittersystem durch Anlegen eines HF-Wechselfeldes (20MHz) getrennt. Dabei liegt die Gesamttransmission bei etwa <20%. Das entspricht einer Ionenstromdichte von 1-100 µA/cm². Für bestimmte Anwendungen, bei der größere Stromdichten ohne Massenseparation verwendet werden können, kann der sog. IS-Mode (engl.: Ion-Source-Mode) benutzt werden.

Die Ionenquelle erlaubt im RAH-Mode neben der Verhinderung von Verunreinigungen im Ionenstrahl eine gezielte Auswahl spezifischer Ionenarten mit bestimmten Ladungszuständen. Ihr Nachteil sind eine geringere Ionenenergie eV und eine geringere Ionenstromdichte (Eᵢₒₙ< 800 eV und jᵢₒₙ <500 µA/cm² im nichtmassenseparierenden IS-Mode bzw. Eᵢₒₙ <500 eV und jᵢₒₙ <50 µA/cm² beim massenseparierenden RAH-Mode). Für eine genaue Beschreibung der Funktionsweise der Ionenquelle wird auf die entsprechende Literatur (Quelle: K. Otte. A. Schindler, F. Bigl, and H. Schlemm, Rev. Sci. Instrum., 69, 1499 (1998)) verwiesen.

Ionenstromdichten werden für den Ionenstrom direkt nach dem Austritt aus der Quelle zwischen 10⁻⁵ µA/cm² und 10⁵ µA/cm², vorzugsweise zwischen 10⁻³ µA/cm² und 10³ µA/cm², noch bevorzugter zwischen 1 µA/cm² und 500 µA/cm² offenbart. Die entsprechende Ionenstromdichte an der Substratoberfläche ist bevorzugt gleich der Ionenstromdichte der Dichte. Im Allgemeinen kommt es allerdings zu einer gewollten und/oder ungewollten Abschwächung, insbesondere auch durch die Divergenz des Ionenstroms. Die Ionenstromdichten des Ionenstroms an der Substratoberfläche liegt zwischen 10⁻⁵ µA/cm² und 10⁵ µA/cm², vorzugsweise zwischen 10⁻³ µA/cm² und 10³ µA/cm², noch bevorzugter zwischen 1 µA/cm² und 500 µA/cm².

### Das Arbeitsgas (erste und/oder zweite Komponente)

Das Arbeitsgas ist nicht Teil der Erfindung.

Als Arbeitsgas werden insbesondere folgende Atom- bzw. Molekülsorten verwendet:
- Formiergas FG ( Argon + Wasserstoff) und/oder
- Formiergas RRG (Wasserstoff + Argon) und/oder
- Formiergas NFG (Argon + Stickstoff und/oder
- Wasserstoff, insbesondere rein, und/oder
- Argon, insbesondere rein.

| Gasmischung FG | Ar (%) | H (%) | Gasmischung RFG | H(%) | Ar (%) | Gasmischung NFG | Ar (%) | N2 (%) |
|---|---|---|---|---|---|---|---|---|
| FG 0 | 100 | Atmosphäre (10 sccm) | RFG 0 | 100 | Atmosphäre (10 sccm) | NFG 0 | 100 | Atmosphäre (10 sccm) |
| FG 1 | 96 | 4 | RFG 1 | 100 | 0 | NFG 1 | 95 | 5 |
| FG 2 | 90 | 10 | RFG 2 | 95 | 5 | NFG 2 | 90 | 10 |
| FG 3 | 80 | 20 | RFG 3 | 90 | 10 | NFG 3 | 80 | 20 |
| FG 4 | 70 | 30 | RFG 4 | 70 | 30 | NFG 4 | 70 | 30 |
| FG 5 | 50 | 50 | RFG 5 | 50 | 50 | NFG 5 | 50 | 50 |
| Tabelle 1: Die Tabelle zeigt eine Auflistung von drei beispielhaften Gasmischungen, FGx, RFGx und NFGx mit ihren jeweiligen Anteilen an Argon und Wasserstoff, bzw. Argon und Stickstoff. | | | | | | | | |

### Die Anlage

Die Anlage ist nicht Teil der Erfindung.

In diesem Abschnitt wird das Verfahren zur Reinigung der Substratoberfläche mittels der Formiergase RFGx (Wasserstoffanteil 100% bis 50% mit Ar von 0% bis 50 %) beschrieben. Die Anlage besteht aus einer Ionenstrahlquelle, und einem Substratprobenhalter mit einem optionalen Heizer. Das Substrat wird auf dem Substratprobenhalter fixiert. Zum Betrieb der Ionenquelle wird eine kontrollierte Menge von Formiergas eingeleitet. Der Gasfluss wird insbesondere zwischen 0.001 und 100000 sccm/min, vorzugsweise zwischen 0.01 und 10000 sccm/min, noch bevorzugter zwischen 0.1 und 1000 sccm/min, am bevorzugtesten zwischen 1 und 100 sccm/min eingestellt. Der Druck in der Prozesskammer hängt von der Art des verwendeten Gases sowie vom verwendeten Pumpsystem ab, wird allerdings zwischen 10⁻⁸ mbar und 1 bar, vorzugsweise zwischen 10⁻⁷ mbar und 10⁻² bar, noch bevorzugter zwischen 10⁻⁶ mbar und 10⁻³ bar eingestellt. Die Potentialdifferenz zwischen der Ionenquelle und der Substratoberfläche wird insbesondere zwischen 1V und 5000V, mit Vorzug zwischen 30 V und 2500 V, am bevorzugtesten zwischen 50 V bis 800 V eingestellt. Die Ionenstrahlstromdichte am Substrat liegt insbesondere im Bereich zwischen 0.001 und 5000 µA/cm², vorzugsweise zwischen 0.01 und 2500 µA/cm², noch bevorzugter zwischen 0.1 und 1000 µA/cm², am bevorzugtesten zwischen 1 und 500 µA/cm². Vorzugsweise wird ein Ioneneinfallswinkel kleiner 50°, mit Vorzug kleiner 40°, mit größerem Vorzug kleiner 30°, mit größtem Vorzug kleiner 22° verwendet. Die Bestrahlungsdauer und die Aufheizung der Substratoberfläche hängen insbesondere von der Art des verwendeten Halbleitermaterials und der Dicke der Kontaminationsschicht auf den Oberflächen ab. Der Abstand des Substrats zur Ionenquelle wird insbesondere zwischen 1 und 100 cm, vorzugsweise zwischen 10 und 80 cm, mit größerem Vorzug zwischen 20 und 50 cm, am bevorzugtesten bei ca. 30 cm (von der Austrittsöffnung der Ionenquelle gemessen) eingestellt. Das Aufheizen der Substratoberfläche auf eine bestimmte Temperatur hängt auch von der Art des verwendeten Halbleitermaterials. Die passivierende Wirkung des Wasserstoffs wird allgemein und im einfachsten Fall durch folgende chemische Reaktionen beschrieben (Quelle: A. J. Pearton and J. W. Lee, vol. 61, Edited by N. H. Nickel (Academic press, San Diego) p. 442 (1999)):

*D⁺ + H⁻* → {*DH*}⁰ bzw. A⁻ + *H⁺* → {*AH*}⁰.

wobei D⁺ einen ionisierten Donator und A⁻ einen ionisierten Akzeptor darstellt.

Ar + e⁻ → *Ar* +2*e*

In einem speziellen Beispiel können mehrere Ionenquellen an die Prozesskammer, insbesondere Hochvakuumionenkammer angeschlossen werden, insbesondere mehr als 1, mit Vorzug mehr als 2, mit größerem Vorzug mehr als 3. Durch den Einsatz mehrere Ionenquellen kann einerseits die Ionendichte an der Oberfläche des Substrats erhöht und besser gesteuert werden. Des Weiteren erlauben mehrere Ionenquellen auch den Einsatz mehrerer unterschiedlicher Ionensorten, die während der Herstellung voneinander getrennt vorliegen und sich erst nach dem Verlassen der Ionenquelle, insbesondere erst an oder kurz vor der Substratoberfläche, treffen. Die erfindungsgemäße Methode kann zur Reinigung aller Arten von Substratoberflächen verwendet werden. Mit besonderem Vorzug eignet sich die Methode allerdings zur Reinigung von Substratoberflächen aus folgenden Materialien/Materialkombinationen:
▪ Silizium, Thermisch oxidiertes Silizium, Quarz, Zerodur, Siliziumkarbide, Molybdän und/oder 3A-5B Halbleitermaterialen,
▪ für spezielle Anwendungen:
   ∘ Homogene Halbleiterstrukturen beim direkt-Wafer-Bonden und/oder
   ∘ GaAs/GaAs, InP/InP, Ge/Ge, Si/Si, Si, SiO₂ und/oder
   ∘ Heterogene Halbleiterstrukturen beim direkt-Wafer-Bonden und/oder
   ∘ GaAs/InP, GaAs/Ge, GaAs/Si, Ge/Si, Ge/InP, InP/Si und/oder
   ∘ Metalle und/oder
   ∘ Cu, Al, W, Mo, Ag, Au, Pt, Zn, Ni, Co und/oder
   ∘ Legierungen und/oder
   ∘ einer Kombination beliebiger, insbesondere vorgenannter, Materialien

Nachdem die Substratoberflächen erfindungsgemäß gereinigt worden sind, können sie einem weiteren Prozesschritt zugeführt werden. Denkbar sind Lithographieprozesse wie Imprintprozesse oder Photolithographie, Belackungsprozesse, Ätzprozesse, nasschemische Reinigunsprozesse und/oder Vakuumabscheideprozesse. Zu den erfindungsgemäß bevorzugten Vakuumabscheideprozessen zählen insbesondere:
- Physcial Vapour Deposition (PVD),
- Chemical Vapour Deposition (CVD),
- Molekularstrahlepitaxie (MPE),
- Plasma Enhanced Chemical Vapour Deposition (PECVD),
- Plasma Enhanced Physcial Vapour Deposition (PEPVD),
- Atomic Layer Deposition (ALD).

Mit besonderem Vorzug eignet sich die erfindungsgemäße Methode zur Reinigung der Substratoberfläche zur Vorbereitung für einen anschließenden Bondvorgang mit einer zweiten Substratoberfläche eines zweiten Substrats. Vor allem bei einem Permanentbondprozess wie einem Metallbondprozess oder einem Fusionsbondprozess werden die beiden Substratoberflächen bevorzugt eine extrem hohe Reinheit und Ebenheit aufweisen, um eine gute Verbindung der beiden Substratoberflächen zu ermöglichen. Jede Art von Verunreinigung hemmt den Bondprozess entscheidend. Die zweite Substratoberfläche wird/ist vorzugsweise mit demselben Verfahren gereinigt. Mit besonderem Vorzug handelt es sich um einen Direktbond. Bei der Kontaktierung zweier erfindungsgemäß behandelter Metalloberflächen erfolgt mit Vorzug automatisch ein Permanentbond. Bei Substratoberflächen wie beispielsweise Silizium oder Siliziumoxid kann auch zuerst ein sogenannter Prebond erfolgen, der durch einen anschließenden Wärmebehandlungsprozess in einen Permanentbond überführt wird. Die Erzeugung des Prebonds erfolgt vorzugsweise bei Raumtemperatur. In einer ganz besonders bevorzugten Ausführungsform sind die Substratoberflächen so rein, dass die zur Herstellung des permanenten Bonds notwendige Temperatur auf ein Minimum reduziert werden kann. Im idealsten Fall erfolgt die Erzeugung des Permanentbondes für alle Arten von Substratoberflächen sofort und ohne einen Prebondschritt, insbesondere ohne einen zusätzlichen Wärmebehandlungsschritt.

Unter einem Direktbond versteht man dabei die Verbindung zweier Substratoberflächen alleine durch kovalente (atomare) Bindungen. In einem ersten Schritt erfolgt die Ausbildung eines sogenannten Prebonds, der sich durch eine, immer noch reversible, daher lösbare, Verbindung zwischen den beiden Substratoberflächen, hervorgerufen durch van-der-Vaals Kräfte, auszeichnet. Sind die beiden Substratoberflächen erst einmal durch einen Prebond miteinander verbunden, ist zumindest deren weitere bzw. erneute Verschmutzung nicht mehr möglich. Der Prebond kann danach durch eine Wärmebehandlung zu einem permanenten, daher irreversiblen, nicht mehr lösbaren, Direktbond umgewandelt werden. Der Direktbond zeichnet sich insbesondere durch die Ausbildung kovalenter Verbindungen zwischen Substratoberflächen aus. Diese kovalenten Verbindungen sind insbesondere kovalente Si-Si oder Si-O Verbindungen. Daher wird die beschriebene Anlage vor allem für einen Prozess verwendet, bei dem mindestens einmal zwei Substrate miteinander verbondet werden müssen. Mit besonderem Vorzug ist die Anlage daher ein Teil eines Vakuumclusters, noch bevorzugter eines Hochvakuumclusters, ganz bevorzugt eines Ultrahochvakuumclusters und wird in diesem vor allem in Zusammenhang mit einer Ausrichtungsanlage und/oder einem Bonder verwendet um Substrate in einem entsprechende Prozess zu reinigen und für einen Bond vorzubereiten. Der Druck in einem der genannten Vakuumcluster ist insbesondere kleiner als 1bar, vorzugsweise kleiner als 10⁻¹ mbar, noch bevorzugter kleiner als 10⁻³ mbar, am bevorzugtesten kleiner als 10⁻⁵ mbar, am allerbevorzugtesten kleiner als 10⁻⁸ mbar.

Die erfindungsgemäße Methode kann auch zur Oberflächenreinigung von Substraten dienen, die über einen metallischen Bond, insbesondere einem Diffusionsbond, einem eutektischen Bond, einem anodischen Bond oder einem beliebigen anderen Bond miteinander verbunden werden. Insbesondere kann die erfindungsgemäße Methode daher auch für die Reinigung von Metall und/oder Keramikoberflächen verwendet werden.

Die Anlage wird mit besonderem Vorzug verwendet, um die Oberflächen von Substraten zu reinigen, die innerhalb desselben Vakuumclusters von einer Ausrichtungsanlage (engl.: aligner) zueinander ausgerichtet, und von einem Bonder miteinander verbondet werden. Bei den Ausrichtungsanlagen kann es sich dabei beispielsweise um eine Ausrichtungsanlage wie in AT 405 775 B, PCT/EP 2013/062473 oder um die PCT/EP 2013/075831 handeln. Mit besonderem Vorzug werden die Substrate zwischen der Ausrichtungsanlage und dem Bonder mittels magnetischer Elemente fixiert. Eine derartige Fixiereinrichtung wird ausführlich in der Patentschrift PCT/EP 2013/056620 erwähnt.

### Beispiele zu reinigender Oberflächen

Im folgenden Abschnitt werden mehrere optimale Parametersätze angegeben, die bei den erwähnten Substratoberflächen zu einer vollständigen Entfernung der Verunreinigungen, insbesondere der Kohlenstoffhaltigen-Verunreinigungen und native Oxiden, geführt hat.

### GaAs Substratoberflächen

Der folgende Prozess wird bei GaAs Oberflächen hauptsächlich aber nicht ausschließlich zur Oxidentfernung genutzt. Der Prozess ist nicht Teil der Erfindung.

Die verwendeten Arbeitsgase für GaAs Oberflächen sind die Formiergasgemische RFG1 (100% Wasserstoff) oder RFG2 (siehe Tabelle 1). Die Ionenenergie liegt dabei zwischen 100 eV und 500 eV, mit Vorzug zwischen 200 eV und 400 eV, am bevorzugtesten bei genau 300 eV. Die Stromdichte liegt zwischen 2.5 µA/cm² und 6.5 µA/cm², mit Vorzug zwischen 3.5 µA/cm² und 5.5 µA/cm², mit größtem Vorzug bei genau 4.5 µA/cm². Die Temperatur der Substratoberfläche liegt zwischen 100°C und 200°C, mit Vorzug zwischen 125°C und 175°C, mit größtem Vorzug bei genau 150°C. Die Behandlungsdauer der Substratoberfläche beträgt mehr als 10s, mit Vorzug mehr als 50s, mit größerem Vorzug mehr als 100s, mit größtem Vorzug mehr als 300s. Die Ionendosis der Ionen liegt zwischen 10¹² Ionen/cm²s und 10¹⁶ Ionen/cm²s, mit größerem Vorzug zwischen 10¹³ Ionen/cm²s und 10¹⁵ Ionen/cm²s, mit größtem Vorzug bei genau 1.5 * 10¹⁴ Ionen/cm²s.

Der Mechanismus der Oxidentfernung von den GaAs Oberflächen durch den Beschuss mit H-Ionen basiert wahrscheinlich auf der chemischen Reaktion der Wasserstoffionen oder von radikalem Wasserstoff mit dem Arsenoxid. Das entstehende Arsenoxid verdampft unter Vakuum. Die entsprechende chemische Reaktion lautet

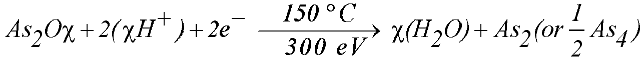

Dabei ist χ= 3 oder 5, entsprechend den verschiedenen Oxiden des Arsens an der GaAs-Oberfläche. Die Elektronen stammen aus einem Neutralisier oder Leitungsband der "potentialfreien Probe" (Quelle: E. Petit, F. Houzay, and J. Moison, J. Vac. Sci. Technol. A 10, 2172 (1992)).

Einen entsprechenden Vorgang erwartet man bei der Reinigung des Galliumoxids. Der Prozess ist nicht Teil der Erfindung.

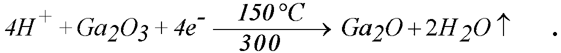

Die Sublimation des Ga₂O ist ebenfalls der entscheidende Schritt für die Entfernung des Ga-Oxids von der Substratoberfläche. Denkbar ist auch, dass bei geringerer Temperatur, insbesondere bei Temperaturen unterhalb von 200°C, keine Sublimation von Ga₂O, sondern eine Reduktion des Galliumarsenids durch atomaren Wasserstoff stattfindet. Dadurch entsteht Gallium und Wasser, welches entsprechend verdampft.

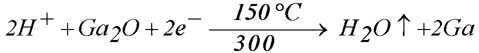

### Ge-Substratoberflächen

Der folgende Prozess wird bei Germanium-Oberflächen hauptsächlich zur Oxidentfernung und zur Reinigung von organischen Verbindungen genutzt. Der Prozess ist nicht Teil der Erfindung.

Die verwendeten Arbeitsgase für Ge - Oberflächen sind die Formiergasgemische RFG1, RFG3, RFG4 und RFG5 (siehe Tabelle 1). Die Ionenenergie liegt insbesondere zwischen 100 eV und 800 eV, mit Vorzug zwischen 150 eV und 400 eV, am bevorzugtesten bei genau 350 eV, 200 eV, 400 eV (sieh Tabelle 2). Die Stromdichte liegt zwischen 4.5 µA/cm² und 8.5 µA/cm², mit Vorzug zwischen 5.5 µA/cm² und 7.5 µA/cm², mit größtem Vorzug bei genau 6.5 µA/cm². Die Temperatur der Substratoberfläche liegt bevorzugt zwischen 275°C und 350°C, mit Vorzug zwischen 300°C und 325°C, mit größtem Vorzug bei genau 300°C. Die Behandlungsdauer der Substratoberfläche beträgt insbesondere mehr als 10s, mit Vorzug mehr als 300s, mit größerem Vorzug mehr als 600s, mit größtem Vorzug mehr als 1200s. Die Ionendosis des Plasmas liegt insbesondere zwischen 10¹² Ionen/cm²s und 10¹⁶ Ionen/cm²s, mit größerem Vorzug zwischen 10¹³ Ionen/cm²s und 10¹⁵ Ionen/cm²s, mit größtem Vorzug bei genau 5 x 10¹⁴ Ionen/cm²s.

| Arbeitsgas | Ionenenergie | Stromdichte | SubstratTemperatur | Beschusszeit |
|---|---|---|---|---|
| RFG1 | 350 eV | 4,5µA/cm2 | 350 °C | 25 min |
| RFG2 | 300 eV | 4,5µA/cm2 | 200 °C | 8 min |
| RF G3 | 300 eV | 4,5µA/cm2 | 150 °C | 4-5 min |
| RFG5 | 500 eV | 500µA/cm2 | RT °C | 5 min |
| Tabelle 2: Bevorzugte Prozessparameter für die Reinigung einer Germaniumsubstratoberfläche für die unterschiedlichen Gasgemische. | | | | |

Die vollständige Entfernung der nativen Oxide und des Kohlenstoffs von der Ge-Oberfläche, bis auf einen relativ geringen Anteil (<1%), der auch durch Verunreinigungen in der Prozesskammer verursacht werden kann, wurde nach den Prozessparametern der Tabelle 2 durch Ionenbeschuss realisiert. Wird die Oberflächentemperatur von Raumtemperatur auf ca. 350°C erhöht, können der Kohlenstoff und die Oxidschichten komplett von der Germaniumsubstratoberfläche entfernt werden. Die mögliche chemische Reaktion zur Entfernung des Germaniumoxids durch den Wasserstoffionenstrahl kann wie folgt beschrieben werden:

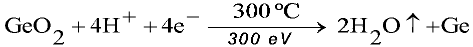

### InP-Substratoberflächen

Der folgende Prozess wird bei InP-Oberflächen hauptsächlich aber nicht ausschließlich zur Oxidentfernung genutzt. Dieser Prozess ist nicht Teil der Erfindung.

Die verwendeten Arbeitsgase für InP-Oberflächen sind die Formiergasgemische RFG1, RFG3, und NFG5 (50% Stickstoff + 50% Argon). Die Ionenenergie liegt zwischen 100 eV und 500 eV, mit Vorzug zwischen 200 eV und 400 eV, am bevorzugtesten bei genau 300 eV. Die Stromdichte liegt zwischen 2.5 µA/cm² und 6.5 µA/cm², mit Vorzug zwischen 3.5 µA/cm² und 5.5 µA/cm², mit größtem Vorzug bei genau 4.5 µA/cm². Die Temperatur der Substratoberfläche liegt zwischen 125°C und 225°C, mit Vorzug zwischen 150°C und 200°C, mit größtem Vorzug bei genau 175°C. Die Behandlungsdauer der Substratoberfläche beträgt mehr als 10 s, mit Vorzug mehr als 100s, mit größerem Vorzug mehr als 300s, mit größtem Vorzug mehr als 600 s. Die Ionendosis des Plasmas liegt zwischen 10¹² Ionen/cm²s und 10¹⁶ Ionen/cm²s, mit größerem Vorzug zwischen 10¹³ Ionen/cm²s und 10¹⁵ Ionen/cm²s, mit größtem Vorzug bei genau 1.5x10¹⁴ Ionen/cm²s.

| Arbeitsgas | Ionenenergie | Stromdichte | Substrat Temperatur | Beschusszeit |
|---|---|---|---|---|
| RFG1 | 300 eV | 4,5µA/cm2 | 175 °C | 10 min |
| RF G3 | 200 eV | 4,5µA/cm2 | 200 °C | 5 min |
| NFG5 | 200 eV | 4,5µA/cm2 | 150 °C | 2 min |
| Tabelle 3: Bevorzugte Prozessparameter für die Reinigung einer InP Substratoberfläche für die unterschiedlichen Gasgemische. | | | | |

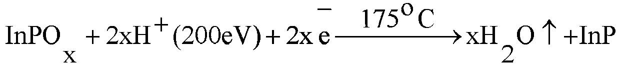

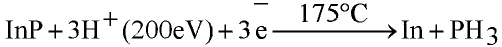

### Si-Substratoberflächen

Die folgenden Prozesse sind nicht Teil der Erfindung.

Die verwendeten Arbeitsgase für Siliziumoberflächen sind die Formiergasgemische FG0, FG1, FG3, RFG5, NFG3 (siehe Tabelle 1). Die Ionenenergie liegt zwischen 150 eV und 800 eV, mit Vorzug zwischen 150 eV und 500 eV, am bevorzugtesten bei genau 500 eV. Die Stromdichte liegt zwischen 20 µA/cm² und 70 µA/cm², mit Vorzug zwischen 30 µA/cm² und 60 µA/cm², mit größtem Vorzug zwischen 40 µA/cm² und 50 µA/cm². Die Temperatur der Substratoberfläche liegt zwischen 300°C und 400°C, mit Vorzug zwischen 325°C und 375°C, mit größtem Vorzug bei genau 350°C. Die Behandlungsdauer der Substratoberfläche beträgt mehr als 10 s, mit Vorzug mehr als 50s, mit größerem Vorzug mehr als 100s, mit größtem Vorzug mehr als 300 s. Die Ionendosis des Plasmas liegt zwischen 10¹³ Ionen/cm²s und 10¹⁷ Ionen/cm²s, mit größerem Vorzug zwischen 10¹⁴ Ionen/cm²s und 10¹⁶ Ionen/cm²s, mit größtem Vorzug bei genau 1.5 * 10¹⁵ Ionen/cm²s.

| Arbeitsgas | Ionenenergie | Stromdichte | Substrat Temperatur | Beschusszeit |
|---|---|---|---|---|
| FG0 | 300 eV | 5mA/cm2 | 300°C | 1 min |
| FG1 | 300 eV | 500µA/cm2 | 300 °C | 3 min |
| FG3 | 200 eV | 5mA/cm2 | 150°C | 0,5-1 min |
| RFG1 | 300 eV | 35µA/cm2 | 350 °C | 5 min |
| RFG5 | 500ev | 500µA/cm2 | RT | 4 min |
| NF G2 | 500eV | 5mA/cm2 | RT | ? |
| Tabelle 4: Bevorzugte Prozessparameter für die Reinigung einer Siliziumsubstratoberfläche für die unterschiedlichen Gasgemische. | | | | |

Die Entfernung des Siliziumoxids wird bevorzugt durch folgende Reaktionsgleichung beschrieben.

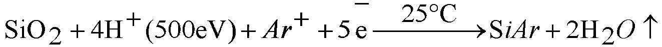

### SiO₂-Substratoberflächen

Die folgenden Prozesse sind nicht Teil der Erfindung.

Die verwendeten Arbeitsgase für thermisches Siliziumoxid sind die Formiergasgemische FG0, FG2, FG5 (siehe Tabelle 1). Die Ionenenergie liegt zwischen 150 eV und 800 eV, mit Vorzug zwischen 475 eV und 525 eV, am bevorzugtesten bei genau 500 eV. Die Stromdichte liegt zwischen 20 µA/cm² und 70 µA/cm², mit Vorzug zwischen 30 µA/cm² und 60 µA/cm², mit größtem Vorzug zwischen 40 µA/cm² und 50 µA/cm². Die Temperatur der Substratoberfläche liegt zwischen 300°C und 400°C, mit Vorzug zwischen 325°C und 375°C, mit größtem Vorzug bei genau 350°C. Die Behandlungsdauer der Substratoberfläche beträgt mehr als 10 s, mit Vorzug mehr als 50s, mit größerem Vorzug mehr als 100s, mit größtem Vorzug mehr als 300 s. Die Ionendosis des Plasmas liegt zwischen 10¹³ Ionen/cm²s und 10¹⁷ Ionen/cm²s, mit größerem Vorzug zwischen 10¹⁴ Ionen/cm²s und 10¹⁶ Ionen/cm²s, mit größtem Vorzug bei genau 1.5 * 10¹⁵ Ionen/cm²s.

| Arbeitsgas | Ionenenergie | Stromdichte | Substrat Temperatur | Beschusszeit |
|---|---|---|---|---|
| FG0 | 500 eV | 5mA/cm² | 300 °C | 1 min |
| FG2 | 500 eV | 400µA/cm² | 150 °C | 50 sec |
| FG5 | 500 eV | 500µA/cm² | RT | 4 min |
| Tabelle 5: Bevorzugte Prozessparameter für die Reinigung einer Siliziumoxidsubstratoberfläche für die unterschiedlichen Gasgemische. | | | | |

Die Entfernung des Siliziumoxids wird bevorzugt durch folgende Reaktionsgleichung beschrieben.

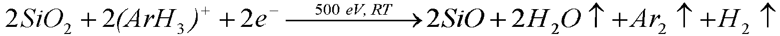

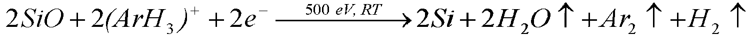

### Zerodur (AlSiO₂) - Oberflächen

Die folgenden Prozesse sind nicht Teil der Erfindung.

Das verwendet Arbeitsgas für Aluminiumsiliziumoxid sind die Formiergasgemische FG 5 (50% Argen und 50% Wasserstoff) (siehe Tabelle 1). Die Ionenenergie liegt zwischen 450 eV und 550 eV, mit Vorzug zwischen 475 eV und 525 eV, am bevorzugtesten bei genau 500 eV. Die Stromdichte liegt zwischen 5 µA/cm2 und 500 µA/cm2, mit Vorzug zwischen 30 µA/cm2 und 60 µA/cm², mit größtem Vorzug bei genau 500 µA/cm2. Die Temperatur der Substratoberfläche liegt zwischen RT und 400°C, mit, mit größtem Vorzug bei genau RT. Die Behandlungsdauer der Substratoberfläche beträgt mehr als 10 s, mit Vorzug mehr als 50s, mit größerem Vorzug mehr als 100s, mit größtem Vorzug bei genau 120 s. Die Ionendosis des Plasmas liegt zwischen 10¹³ Ionen/cm²s und 10¹⁷ Ionen/cm²s, mit größerem Vorzug zwischen 10¹⁴ Ionen/cm²s und 10¹⁶ Ionen/cm²s, mit größtem Vorzug bei genau 1.5 * 10¹⁵ Ionen/cm²s.

Die Quantifizierung der Substratoberfläche vor und nach der Behandlung erfolgte mit Hilfe von Röntgenphotospektroskopie (XPS).

### Allgemeine Beschreibung des erfindungsgemäßen Prozesses

Der erfindungsgemäße Prozess kann insbesondere folgendermaßen gesteuert werden:
Ein erstes Gas, insbesondere Formiergas, noch bevorzugter bestehend aus nur einer Komponente, am bevorzugtesten aus Argon, wird in einer Ionenquelle ionisiert und durch eine Beschleunigungseinheit auf einen Punkt einer Substratoberfläche beschleunigt. Bei der bevorzugten Verwendung eines Breitbandionenstrahls deckt der Ionenstrahl insbesondere das gesamte Substrat ab. Die erste Komponente trifft entweder auf eine nicht verunreinigte Stelle der Substratoberfläche und wird elastisch gestreut, verursacht daher keinerlei Modifikationen/Schäden in der Substratoberfläche und führt damit auch nicht zu einer physikalischen und/oder chemischen Veränderung. Im zweiten denkbaren Fall trifft die erste Komponente auf eine Verunreinigung. Die Bindungsenergie zwischen der Verunreinigung und der Substratoberfläche wird erfindungsgemäß, insbesondere um ein Vielfaches, geringer als die zur Veränderung der Substratoberfläche, selbst notwendige Energie eingestellt. Alternativ oder zusätzlich wird die Bindungsenergie zwischen der Verunreinigung und der Substratoberfläche, insbesondere um ein Vielfaches, kleiner als die kinetische Energie der ersten Komponente eingestellt. Diese ist daher in der Lage, die Verunreinigung von der Substratoberfläche zu entfernen, ohne die Substratoberfläche selbst zu schädigen. In einem zweiten erfindungsgemäßen Schritt wird ein zweites Gas, insbesondere ein Formiergas, noch bevorzugter bestehend aus nur einer Komponente, mit Vorzug Wasserstoff, dazu verwendet, um die sich in der Atmosphäre befindende, abgesputterte Verunreinigung in eine weniger schädliche, sich nicht mehr so leicht auf der Substratoberfläche abscheidende, Verbindung überzuführen. Bei dieser Verbindung handelt es sich mit Vorzug um eine Verbindung, die in entsprechender Umgebung im gasförmigen Zustand vorliegt und somit aus der Prozesskammer ausgetragen werden kann. Das in der Ionenquelle erzeugte Gas kann in einer speziellen Ausführungsform identisch mit dem zweiten Gas sein, welches die Verunreinigungen in eine weniger schädliche, sich nicht mehr so leicht auf der Substratoberfläche abscheidende Verbindung überführt.

Des Weiteren wird eine Anlage offenbart, mit deren Hilfe die erfindungsgemäße Methode möglichst effizient angewandt werden kann.

Die Anlage ist nicht Teil der Erfindung.

Die Anlage besteht aus mindestens einer Ionenquelle, mindestens einer Prozesskammer, mindestens einem Ventil zum Einschleusen eines Arbeitsgases in die Prozesskammer sowie einem Substratprobenhalter zur Fixierung und insbesondere Bewegung des Substrats. Die Anlage ist vorzugsweise Teil eines Clusters, mit größerem Vorzug Teil eines Hochvakuumclusters, mit allergrößtem Vorzug Teil eines Ultrahochvakuumclusters. Der Druck in einem der genannten Vakuumcluster ist insbesondere kleiner als 1bar, vorzugsweise kleiner als 10⁻¹ mbar, noch bevorzugter kleiner als 10⁻³ mbar, am bevorzugtesten kleiner als 10⁻⁵ mbar, am allerbevorzugtesten kleiner als 10⁻⁸ mbar. Vorzugsweise wird die Anlage vor allem zusammen mit einem Bonder und/oder einer Ausrichtungsanlage verwendet um Substrate miteinander zu verbonden.

Des Weiteren wird ein Substrat als Produkt offenbart, welches sich durch eine extreme hohe Oberflächenreinheit und einen sehr gering geschädigten Oberflächenbereich auszeichnet. Das Produkt ist nicht Teil der Erfindung. Die Oberflächenreinheit wird dabei vorzugsweise durch das Verhältnis von Verunreinigungsatomen zu Anzahl der Substratoberflächenatome angegeben. Die Oberflächenreinheit ist dadurch eine dimensionslose Verhältniszahl. Vorzugsweise wird diese sehr kleine Zahl daher in ppm (engl.: parts per million), ppb (engl.: parts per billion) oder ppt (engl.: parts per trillion) angegeben. Vor dem erfindungsgemäßen Reinigungsprozess können die Verunreinigungen die gesamte Substratoberfläche bedecken wodurch die oben definierte Oberflächenreinheit größer gleich 1 wäre. Durch die erfindungsgemäße Methode wird diese Oberflächenreinheit entsprechend reduziert. Die Verunreinigungen der Substratoberfläche sind nach der Anwendung der erfindungsgemäßen Methode kleiner als 1 (10⁶ ppm), mit Vorzug kleiner als 10⁻³ (1000 ppm), mit größerem Vorzug kleiner als 10⁻⁶ (1 ppm), mit größtem Vorzug kleiner als 10⁻⁹ (1 ppt), mit besonderem Vorzug null.

Die Stärke der Schädigung wird am besten durch jenen Tiefenbereich angegeben, innerhalb dessen noch eine Änderung der Mikrostruktur des Substrats nachweisbar ist. Dieser Tiefenbereich ist durch die Anwendung der erfindungsgemäßen Methode kleiner als 10µm, mit Vorzug kleiner als 1µm, mit größerem Vorzug kleiner als 100nm, mit größtem Vorzug kleiner als 10nm, mit allergrößtem Vorzug kleiner als 1nm, am bevorzugtesten allerdings null. Im Idealfall findet also überhaupt keine Schädigung durch den Ionenbeschuss statt. Der Nachweis einer solchen Schädigung kann durch den Vergleich der Mikrostrukturen der Oberfläche, bzw. der oberflächennahen Bereiche, eines mit der erfindungsgemäßen Methode behandelten ersten Substrats mit der Mikrostruktur der Oberfläche, bzw. der oberflächennahen Bereiche, eines nicht mit der erfindungsgemäßen Methode behandelten, aber vorzugsweise aus der gleichen Charge stammenden, zweiten Substrats erfolgen. Die Mikrostruktur wird dabei vorzugsweise mit TEM (Transmissionselektronenmikroskopie) und/oder AFM (engl.: atomic force microscopy) und/oder SEM (engl.: scanning electron microscopy) und/oder Röntgenstreuung und/oder Elektronenstreuung untersucht.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische Darstellung einer ersten Anlage,
- Figur 2: eine schematische Darstellung einer zweiten Anlage,
- Figur 3: eine schematische Darstellung einer dritten Anlage,
- Figur 4: eine schematische Darstellung einer vierten Anlage,
- Figur 5: ein wissenschaftliches Diagramm der Konzentrationsabhängigkeit mehrerer Atome von der Behandlungszeit,
- Figur 6a: ein wissenschaftliches Diagramm der Intensitätsabhängigkeit eines XPS-Signals von der Wellenlänge für das Material Silizium,
- Figur 6b: eine mikroskopische Oberflächenaufnahme einer Substratoberfläche vor der erfindungsgemäßen Behandlung,
- Figur 6c: eine mikroskopische Oberflächenaufnahme einer Substratoberfläche nach der erfindungsgemäßen Behandlung,
- Figur 7: ein wissenschaftliches Diagramm der Intensitätsabhängigkeit eines XPS-Signals von der Wellenlänge für das Material Siliziumoxid,
- Figur 8: ein wissenschaftliches Diagramm der Intensitätsabhängigkeit eines XPS-Signals von der Wellenlänge für das Material Zerodur und
- Figur 9: ein wissenschaftliches Diagramm der Intensitätsabhängigkeit eines XPS-Signals von der Wellenlänge für das Material Gold.

In den Figuren sind gleiche oder gleichwirkende Merkmale mit den gleichen Bezugszeichen gekennzeichnet.

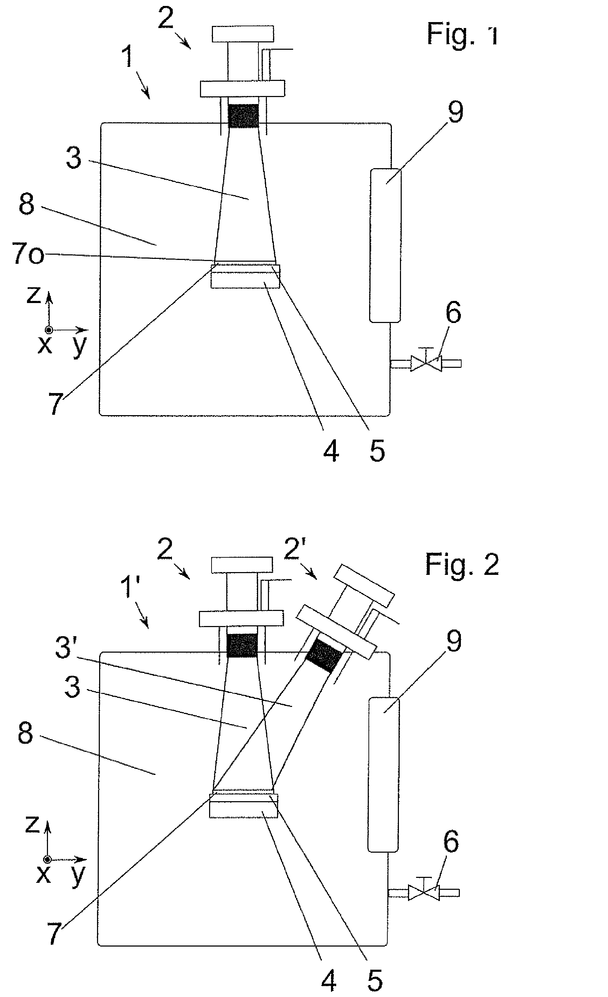

Figur 1 zeigt eine erste Ionensputteranlage 1 mit einer Ionenquelle 2, die einen Ionenstrahl 3, insbesondere einen Breitbandionenstrahl, erzeugt. Dieser trifft auf eine Substratoberfläche 7o eines Substrats 7, welches auf einem Substratprobenhalter 5 fixiert wurde. Der Substratprobenhalter 5 wurde auf einem Tisch 4 fixiert und ist vorzugsweise austauschbar. Das Substrat 7 kann mittels eines Roboters über eine Schleuse 9 in die Prozesskammer 8 geladen werden. Über ein Ventil 6 kann die Prozesskammer 8 evakuiert und/oder mit einem Prozessgas gespült werden. Durch die translatorische und/oder rotatorische Verschiebungsmöglichkeit des Tisches 4 in x- und/oder y- und/oder z-Richtung bzw. um die x-, und/oder y- und/oder z-Achse, kann die Substratoberfläche 7o in jede beliebige Position und Orientierung zum Ionenstrahl 3 gebracht werden.

Das Prozessgas ist vorzugsweise dasselbe Formiergas, das von der Ionenquelle 2 verwendet wird, um den Ionenstrahl 3 zu erzeugen.

Figur 2 zeigt eine zweite Anlage.

Die zweite Ionenquelle 2' kann entweder verwendet werden um ein zweites Formiergas in die Prozesskammer 8 einzubringen oder sie dient zur gezielten Manipulation des Ionenstrahls 3 durch den Ionenstrahl 3'. Denkbar wäre beispielsweise, dass die Ionendichte im Ionenstrahl 3 durch den Ionenstrahl 3' manipuliert wird, indem man ein zweites Ionengas in der zweiten Ionenquelle 2' erzeugt, welches die Ionen im Ionenstrahl 3 der ersten Ionenquelle 2 reduziert bzw. oxidiert. Denkbar ist auch, dass es sich bei der Ionenquelle 2' um eine Elektronenquelle handelt, mit deren Hilfe Elektronen auf den Ionenstrahl 3 geschossen werden. Die Elektronen des Ionenstrahls 3' reduzieren dann die positiv geladenen Ionen des Ionenstrahls 3. Durch hohe Elektronendichten kann auch eine Erhöhung der Oxidationsstufe der Ionen des Ionenstrahls 3 erfolgen, die Ionen werden daher negativer geladen.

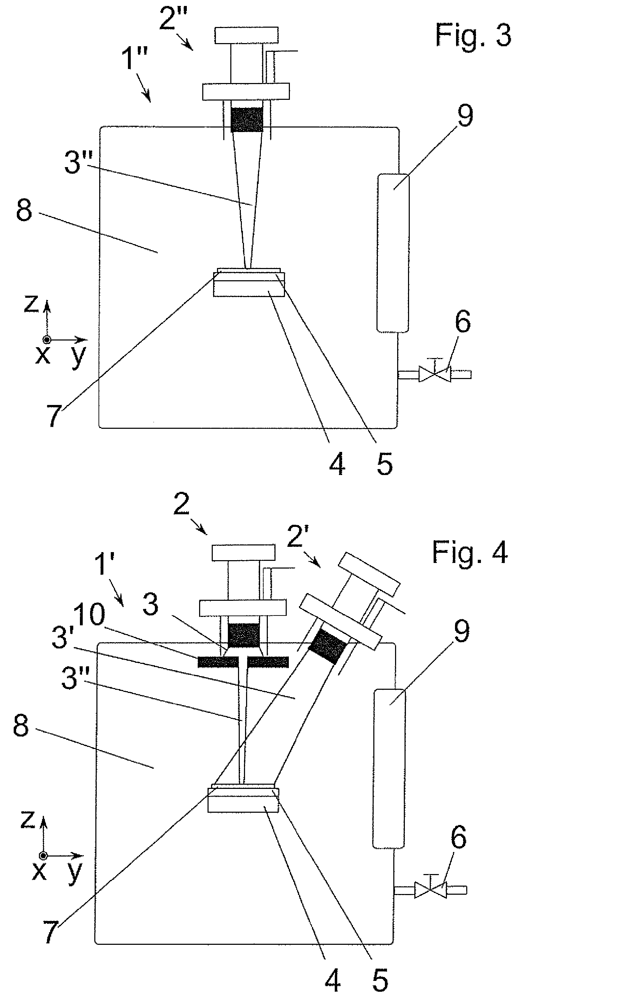

Figur 3 zeigt eine, der Figur 1 ähnliche, dritte Anlage, in der eine Ionenquelle 2" einen Schmalbandionenstrahl 3'' verwendet, um die erfindungsgemäße Reinigung der Substratoberfläche 7o durchzuführen. Um sämtliche gewünschten Stellen an der Substratoberfläche 7o zu erreichen, wird der Substratprobenhalter 5 mit dem Substrat 7 relativ zum Ionenstrahl 3'' bewegt. Die Verwendung mindestens einer weiteren Ionenquelle 2' ist denkbar.

Figur 4 zeigt eine, den Figuren 2 und 3 ähnliche, vierte Anlage, in der eine Ionenquelle 2 einen Breitbandionenstrahl 3 oberhalb einer Blende 10 erzeugt. Die Blende 10 wandelt den Breitbandionenstrahl 3 in einen Schmalbandionenstrahl 3'' um. Die zweite Ionenquelle 2' dient nicht nur zur Manipulation des Ionenstrahls 3" sondern bindet mit besonderem Vorzug vor allem Verunreinigungen, die sich von der Blende 10 ablösen. Diese Verunreinigungen würden sich sonst auf dem Substrat 7 ablagern und dieses Verunreinigen. Die in Figur 4 dargestellte Kombination von Ionenquelle 2, Breitbandionenstrahl 3 und Blende 10 sehr oft verwendet wird, um entsprechende Schmalbandionenstrahlen 3'' zu erzeugen, besitzt entsprechend hohe technische und wirtschaftliche Relevanz. Die Blende 10 wird insbesondere aus Kohlenstoff oder kohlenstoffhaltigem Material gefertigt und ist damit dementsprechend stark an einer, insbesondere organischen, Verschmutzung des Substrats 7 beteiligt. Vorteilhaft kann allerdings mit Hilfe der zweiten, insbesondere als Ionenkanone ausgebildeten, Ionenquelle 2' und/oder dem eingeleiteten Formiergas eine Ablagerung der Verunreinigungen durch die Blende 10 weitestgehend verhindert oder sogar vollkommen ausgeschlossen werden. Der Ionenstrahl 3' der zweiten Ionenquelle 2' kann, bei entsprechender Positionierung der Blende 10 auch zwischen der Blende 10 und der ersten Ionenquelle 2, also im Bereich des Breitbandionenstrahls 3 eingesetzt werden. Vorzugsweise kann die Ionenquelle 2' so geschwenkt werden, dass der Ionenstrahl 3' oberhalb und unterhalb der Blende 10 eingesetzt werden kann. Selbstverständlich kann der Ionenstrahl 3' auch weiterhin zur Reinigung der Substratoberfläche 7o verwendet werden. Um sämtliche gewünschten Stellen an der Substratoberfläche 7o zu erreichen, kann der Substratprobenhalter 5 wieder mit dem Substrat 7 relativ zum Ionenstrahl 3'' bewegt werden.

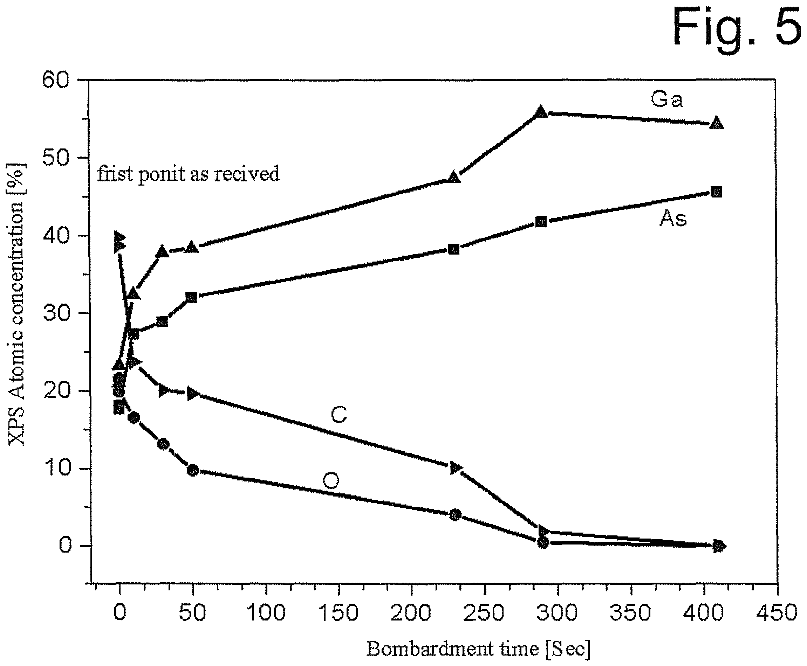

Figur 5 zeigt ein wissenschaftliches Diagramm einer durchgeführten XPS (X-Ray photoelectron spectroscopy) Messung, welches die Atomkonzentration von Gallium, Arsen, Kohlenstoff und Sauerstoff an einer GaAs Substratoberfläche 7o als Funktion der Beschusszeit mit dem Formiergasgemisch und der Ionensputteranlage dargestellt wird. Die Abnahme der Sauerstoff- und Kohlenstoffkonzentration sowie die damit verbundene Zunahme der Gallium- und Arsenkonzentration sind deutlich zu erkennen. Man beachte dabei, dass der hier vorgestellte Reinigungsprozess derartige Ergebnisse bei extrem niedrigen Temperaturen und in sehr kurzer Zeit, sowie ohne eine nennenswerte Schädigung der Substratoberfläche, ermöglicht. Insbesondere versteht man unter nennenswerte Schädigung, eine Veränderung der Mikrostruktur innerhalb eines Tiefenbereichs. Der Tiefenbereich ist insbesondere kleiner als 15 nm, vorzugsweise kleiner als 7nm, noch bevorzugter kleiner als 3nm, am bevorzugtesten kleiner als 1.5nm.

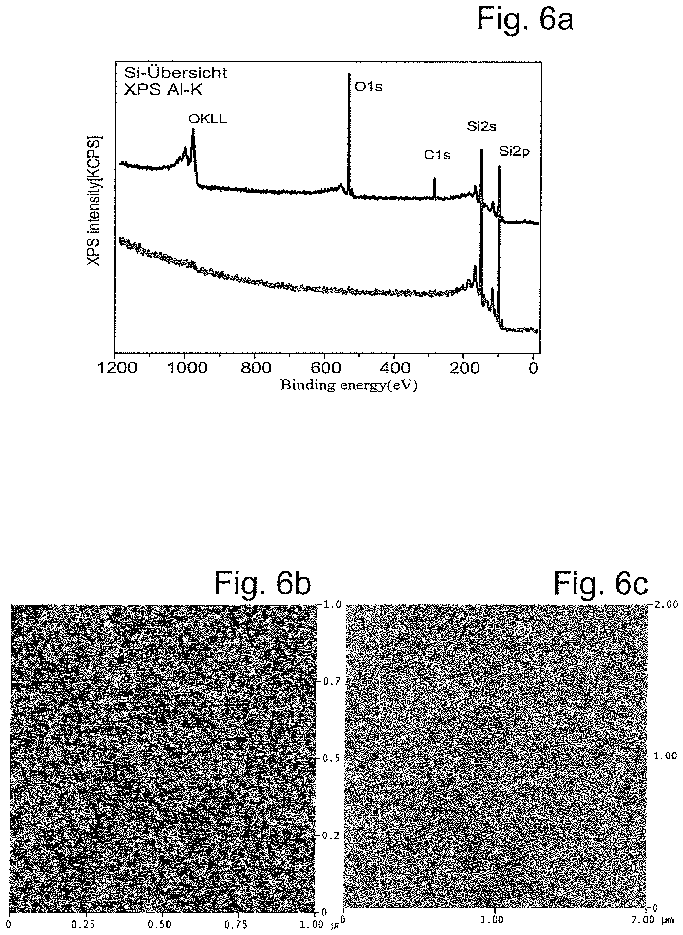

Figur 6a zeigt ein wissenschaftliches Diagramm einer durchgeführten XPS (X-Ray photoelectron spectroscopy) Messung zweier Intensitätsspektren. Das obere Intensitätsspektrum zeigt die Existenz von Sauerstoff und Kohlenstoff, sowie von Silizium durch charakteristische Intensitätsprofile an. Im Unteren Intensitätsspektrum, das nach der erfindungsgemäßen Reinigung der Siliziumoberfläche aufgenommen wurde, sind die charakteristischen Sauerstoff- und Kohlenstoffprofile verschwunden. Figur 6b und 6c zeigen eine AFM (engl.: atomic force microscopy) Aufnahme der untersuchten Substratoberfläche vor und nach der Anwendung der erfindungsgemäßen Methode. Deutlich erkennbar ist die Reduktion der Rauheit durch die Entfernung der Kohlenstoffverunreinigungen sowie der Entfernung des Oxids. Die erfindungsgemäße Methode hat also trotz der Verwendung einer Ionensputtertechnologie nicht zu einer Aufrauhung der Oberfläche geführt, sondern die Verunreinigungen beseitigt und die Substratoberfläche für einen weiteren Prozessschritt optimal vorbereitet.

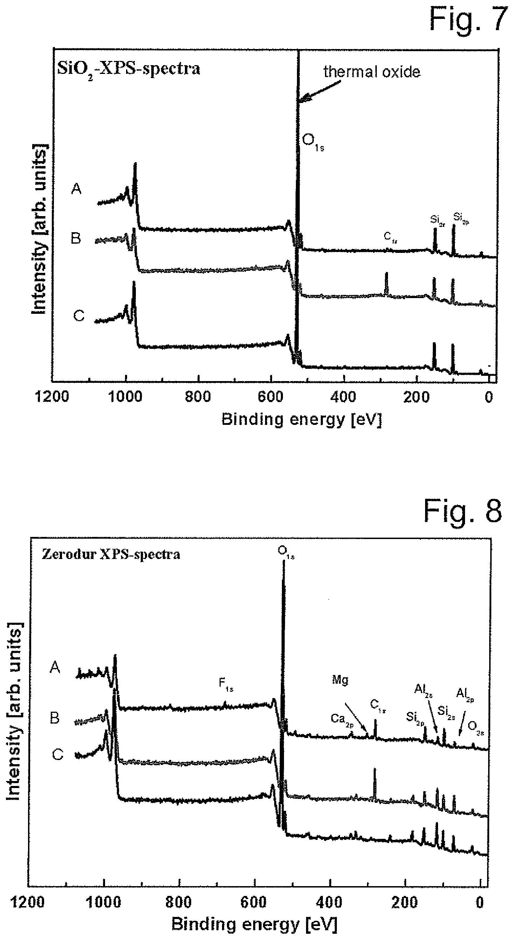

Figur 7 zeigt ein wissenschaftliches Diagramm einer durchgeführten XPS (X-Ray photoelectron spectroscopy) Messung dreier Intensitätsspektren. Das obere Intensitätsspektrum zeigt die Existenz von Kohlenstoff sowie von Sauerstoff des Siliziumdioxids an. In einem ersten Versuch wurde versucht den Kohlenstoff durch reines Argon zu entfernen. Nach dem Ionenbeschuss mit reinem Argon wurde das zweite, das mittlere, Intensitätsprofil aufgenommen. Im zweiten Intensitätsprofil ist deutlich eine Steigerung der Kohlenstoffkonzentration erkennbar. Die Steigerung der Kohlenstoffkonzentration kann viele Ursachen haben. Wichtig ist allerdings, dass der Kohlenstoff aus der Prozesskammer 8 kommt. Er hat sich dort entweder angesammelt, an den Wänden abgelagert, wurde über Teile der Ionensputteranlage oder durch die Schleuse eingeführt. Erst eine erfindungsgemäße Bearbeitung der Substratoberfläche 7o durch die erfindungsgemäße Technik in Zusammenhang mit dem Formiergas liefert eine vom Kohlenstoff befreite Substratoberfläche, wie man es im dritten, unteren Intensitätsprofil durch die Abwesenheit des Kohlenstoffprofils bei derselben Wellenlänge eindeutig erkennen kann.

Analoge Überlegungen gelten für die durchgeführten Versuche an Zerodur gemäß Figur 8.

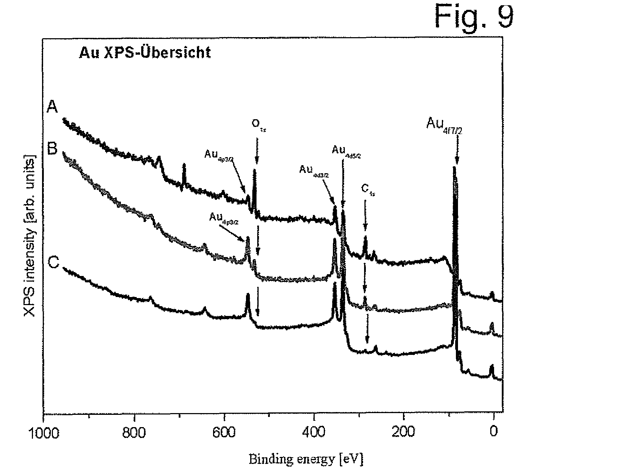

Figur 9 zeigt schließlich die Entfernung von Kohlenstoff an einer Goldoberfläche. Damit kann gezeigt werden, dass die erfindungsgemäße Methode sich auch zur Reinigung von Metalloberflächen bestens eignet. Mit besonderem Vorzug kann die erfindungsgemäße Methode auch zur Reinigung von Metalloberflächen wie Kupfer verwendet werden, um diese in einem weiteren Prozessschritt zu bonden.

### Bezugszeichenliste

- 1: Ionensputteranlage
- 2, 2', 2": Ionenquelle
- 3, 3', 3'': Ionenstrahl
- 4: Tisch
- 5: Substratprobenhalter
- 6: Ventil
- 7: Substrat
- 7o: Substratoberfläche
- 8: Prozesskammer
- 9: Schleuse
- 10: Blende

## Patentansprüche

1. Verfahren zur Oberflächenreinigung einer Substratoberfläche (7o) eines Substrats (7) bei Raumtemperatur mit folgenden Schritten:
- Anordnung der Substratoberfläche (7o) in einer Prozesskammer (8),
- Beaufschlagung der Substratoberfläche (7o) mit einem von einer Ionenstrahlquelle (2, 2', 2") erzeugten, auf die Substratoberfläche (7o) gerichteten Ionenstrahl (3, 3', 3'') zur Ablösung von Verunreinigungen von der Substratoberfläche (7o), wobei der Ionenstrahl (3, 3', 3'') eine erste Komponente aufweist,
- Einleitung einer zweiten Komponente in die Prozesskammer (8) zur Bindung der abgelösten Verunreinigungen,
wobei ein Abstand zwischen einem Substratprobenhalter (5) und einer Austrittsöffnung der Ionenstrahlquelle (2, 2', 2'') kleiner ist als 100 cm, wobei die zweite Komponente gasförmig in die Prozesskammer (8) geleitet wird.

2. Verfahren nach Anspruch 1, bei dem der Abstand zwischen dem Substratprobenhalter (5) und der Austrittsöffnung der Ionenstrahlquelle (2, 2', 2") kleiner ist als 80 cm, bevorzugt kleiner als 60 cm, weiter bevorzugt kleiner als 40 cm ist.

3. Verfahren nach mindestens einem der vorhergehenden Ansprüche, bei dem eine Energie von Ionen an der Substratoberfläche (7o) durch den Abstand des Substrats (7) zur Austrittsöffnung der Ionenstrahlquelle (2, 2', 2") eingestellt wird, insbesondere in Verbindung mit einer Einstellung einer Formiergasdichte, wobei insbesondere Messmittel zur Messung des Abstands vorgesehen werden.

4. Verfahren nach mindestens einem der vorhergehenden Ansprüche, bei dem die Prozesskammer (8) vor der Einleitung der zweiten Komponente evakuiert wird, insbesondere auf einen Druck kleiner 1 bar, mit Vorzug kleiner 10⁻³ bar, mit größerem Vorzug kleiner 10⁻⁵ bar, mit noch größerem Vorzug kleiner 10⁻⁷ bar, noch bevorzugter kleiner 10⁻⁸ bar.

5. Verfahren nach mindestens einem der vorhergehenden Ansprüche, bei dem der Ionenstrahl (3, 3', 3'') so eingestellt wird, dass die Substratoberfläche (7o) mit einer Ionenstrahlstromdichte zwischen 0.001 und 5000 µA/cm², vorzugsweise zwischen 0.01 und 2500 µA/cm², noch bevorzugter zwischen 0.1 und 1000 µA/cm², am bevorzugtesten zwischen 1 und 500 µA/cm² beaufschlagt wird.

6. Verfahren nach mindestens einem der vorhergehenden Ansprüche, bei dem der Ionenstrahl (3, 3', 3'') als, insbesondere die gesamte Substratoberfläche (7o) erfassender, Breitbandionenstrahl ausgebildet ist.

7. Verfahren nach mindestens einem der vorhergehenden Ansprüche, bei dem der Ionenstrahl (3, 3', 3'') so eingestellt wird, dass ein Durchmesser des auf die Substratoberfläche (7o) auftreffenden Ionenstrahls (3, 3', 3'') größer als 1/100, insbesondere größer als 1/10, bevorzugt größer als ½, des Durchmessers der Substratoberfläche (7o) ist.

8. Verfahren nach mindestens einem der vorhergehenden Ansprüche, bei dem die Substratoberfläche (7o) und/oder der erste Ionenstrahl (3, 3', 3'') mit einem von einer zweiten Ionenstrahlquelle (2') erzeugten zweiten Ionenstrahl (3, 3', 3'') beaufschlagt wird/werden.

9. Verfahren nach mindestens einem der vorhergehenden Ansprüche, bei dem das Substrat (7) auf dem, insbesondere translatorisch und/oder rotatorisch, vorzugsweise in X-, Y- und Z-Richtung, bewegbaren, Substratprobenhalter (5) fixiert wird.

## Claims

1. A method for the surface cleaning of a substrate surface (7o) of a substrate (7) at room temperature with the following steps:
- arrangement of the substrate surface (7o) in a process chamber (8),
- bombardment of the substrate surface (7o) with an ion beam (3, 3', 3") generated by an ion beam source (2, 2', 2") and aimed at the substrate surface (7o) to remove impurities from the substrate surface (7o), wherein the ion beam (3, 3', 3") comprises a first component,
- introduction of a second component into the process chamber (8) to bind the released impurities,
wherein a distance between a substrate sample holder (5) and an exit opening of the ion beam source (2, 2', 2") is less than 100 cm, wherein the second component is conveyed in gaseous form into the process chamber (8).

2. The method according to claim 1, in which the distance between the substrate sample holder (5) and the exit opening of the ion beam source (2, 2', 2") is less than 80 cm, preferably less than 60 cm, further preferably less than 40 cm.

3. The method according to at least one of the preceding claims, in which an energy of ions at the substrate surface (7o) is adjusted by the distance of the substrate (7) to the exit opening of the ion beam source (2, 2', 2''), in particular in connection with an adjustment of a forming gas density, wherein in particular measuring means for measuring the distance are provided.

4. The method according to at least one of the preceding claims, in which the process chamber (8) is evacuated before the introduction of the second component, especially down to a pressure of less than 1 bar, preferably less than 10⁻³ bar, with greater preference less than 10⁻⁵ bar, with still greater preference less than 10⁻⁷ bar, still more preferably less than 10⁻⁸ bar.

5. The method according to at least one of the preceding claims, in which the ion beam (3, 3', 3") is adjusted such that the substrate surface (7o) is bombarded with an ion beam current density between 0.001 and 5000 µA/cm², preferably between 0.01 and 2500 µA/cm², more preferably between 0.1 and 1000 µA/cm², and most preferably between 1 and 500 µA/cm².

6. The method according to at least one of the preceding claims, in which the ion beam (3, 3', 3") is configured as a broad-band ion beam, in particular one that captures the entire substrate surface (7o).

7. The method according to at least one of the preceding claims, in which the ion beam (3, 3', 3") is adjusted such that a diameter of the ion beam (3, 3', 3") striking the substrate surface (7o) is greater than 1/100, in particular greater than 1/10, preferably greater than ½ of the diameter of the substrate surface (7o).

8. The method according to at least one of the preceding claims, in which the substrate surface (7o) and/or the first ion beam (3, 3', 3") is/are bombarded with a second ion beam (3, 3', 3") generated by a second ion beam source (2').

9. The method according to at least one of the preceding claims, in which the substrate (7) is fixed on the substrate sample holder (5) which can be moved in particular in a translatory manner and/or in a rotary manner, preferably in the X, Y and Z direction.

## Revendications

1. Procédé de nettoyage en surface d'une surface de substrat (7o) d'un substrat (7) à température ambiante, comportant les étapes suivantes :
- disposition de la surface de substrat (7o) dans une chambre de traitement (8),
- application sur la surface du substrat (7o) d'un faisceau ionique (3, 3', 3") produit par une source de faisceau ionique (2, 2', 2"), dirigé vers la surface du substrat (7o) pour éliminer les impuretés de la surface du substrat (7o), le faisceau ionique (3, 3', 3") ayant un premier composant,
- introduction d'un second composant dans la chambre de traitement (8) pour lier les impuretés dissoutes,
une distance entre un support d'échantillon de substrat (5) et une ouverture de sortie de la source de faisceau ionique (2, 2', 2") étant inférieure à 100 cm, le second composant étant acheminé sous forme gazeuse dans la chambre de traitement (8).

2. Procédé selon la revendication 1, dans lequel la distance entre le support de substrat (5) et l'orifice de sortie de la source de faisceau ionique (2, 2', 2") est inférieure à 80 cm, préférentiellement inférieure à 60 cm et plus préférentiellement inférieure à 40 cm.

3. Procédé selon au moins une des revendications précédentes, dans lequel une énergie d'ions sur la surface du substrat (7o) est réglée par la distance du substrat (7) par rapport à l'ouverture de sortie de la source de faisceau ionique (2, 2', 2"), en particulier en liaison avec un réglage de la densité de gaz de formage, en prévoyant notamment des instruments de mesure de la distance.

4. Procédé selon au moins une des revendications précédentes, dans lequel la chambre de traitement (8) est évacuée avant l'introduction du second composant, en particulier à une pression inférieure à 1 bar, de préférence inférieure à 10⁻³ bar, préférentiellement inférieure à 10⁻⁵ bar, plus préférentiellement inférieure à 10⁻⁷ bar, encore plus préférentiellement inférieure à 10⁻⁸ bar.

5. Procédé selon au moins une des revendications précédentes, dans lequel le faisceau ionique (3, 3', 3") est réglé de telle manière que la surface du substrat (7o) soit dotée d'une densité de faisceau ionique comprise entre 0,001 et 5000 µA/cm², préférentiellement entre 0,01 et 2500 µA/cm², plus préférentiellement entre 0,1 et 1000 µA/cm², encore plus préférentiellement entre 1 et 500 µA/cm².

6. Procédé selon au moins une des revendications précédentes, dans lequel le faisceau ionique (3, 3', 3") est formé sous forme d'un faisceau ionique à bande large couvrant en particulier toute la surface du substrat (7o).

7. Procédé selon au moins une des revendications précédentes, dans lequel le faisceau ionique (3, 3', 3") est réglé de manière à ce que le diamètre du faisceau ionique (3, 3', 3") incident sur la surface du substrat (7o) soit supérieur à 1/100, et plus particulièrement supérieur à 1/10, de préférence supérieur à 1/2, du diamètre de la surface du substrat (7o).

8. Procédé selon au moins l'une des revendications précédentes, dans lequel la surface du substrat (7o) et/ou le premier faisceau ionique (3, 3', 3") sont sollicités par un second faisceau ionique (3, 3', 3") produit par une seconde source de faisceau ionique (2').

9. Procédé selon au moins une des revendications précédentes, dans lequel le substrat (7) est fixé sur le support d'échantillon de substrat mobile (5), notamment translatoire et/ou rotatif, de préférence dans les directions X, Y et Z.
